# EUROPEAN PATENT APPLICATION

(11) **EP 1 959 300 A1**
(43) Date of publication of application: **20.08.2008**
(21) Application number: 08002527.3
(22) Date of filing: 12.02.2008
(51) Int. Cl.: G03F 7/039

(54) **Resist composition and pattern forming method using the same**

(30) Priority: 14.02.2007 JP 2007033742
(71) Applicant: FUJIFILM Corporation, Minato-ku Tokyo (JP)
(72) Inventor: Makino, Masaomi, Haibara-gun Shizuoka (JP); Hoshino, Wataru, Haibara-gun Shizuoka (JP); Mizutani, Kazuyoshi, Haibara-gun Shizuoka (JP)
(74) Representative: HOFFMANN EITLE

(57) **Abstract**

A resist composition includes: (A) a resin containing a repeating unit having a specific secondary benzyl structure; and (B) a compound capable of generating an acid upon irradiation with actinic rays or radiation, and a pattern forming method using the composition.

## Description

### Background of the Invention

### 1. Field of the Invention

The present invention relates to a resist composition suitable for use in the ultramicrolithography process such as production of VLSI or a high-capacity microchip or in other photofabrication processes, and a pattern forming method using the same. More specifically, the present invention relates to a resist composition capable of forming a high-resolution pattern by using KrF excimer laser light, electron beam, EUV light or the like, and a pattern forming method using the same. That is, the present invention relates to a resist composition suitably usable for fine processing of a semiconductor device, where KrF excimer laser light, electron beam or EUV light is used, and a pattern forming method using the same.

### 2. Description of the Related Art

In the process of producing a semiconductor device such as IC and LSI, fine processing by lithography using a photoresist composition has been conventionally performed. Recently, the integration degree of an integrated circuit is becoming higher and formation of an ultrafine pattern in the sub-micron or quarter-micron region is required. To cope with this requirement, the exposure wavelength also tends to become shorter, for example, from g line to i line or further to KrF excimer laser light. At present, other than the excimer laser light, development of lithography using electron beam, X ray or EUV light is proceeding.

The lithography using electron beam or EUV light is positioned as a next-generation or next-next-generation pattern formation technique and a high-sensitivity resist is being demanded. Particularly, in order to shorten the wafer processing time, the elevation of sensitivity is very important, but when high sensitivity of a positive resist to electron beam or EUV is sought for, worsening of the defocus latitude depended on line pitch is incurred and development of a resist satisfying these properties at the same time is strongly demanded. The defocus latitude depended on line pitch as used herein means a difference in the pattern dimension between a high density portion and a low density portion of a resist pattern and when this difference is large, the process margin is disadvantageously narrowed at the actual pattern formation. How to reduce this difference is one of important problems to be solved in the resist technology development. The high sensitivity is in a trade-off relationship with good defocus latitude depended on line pitch and it is very important how to satisfy these properties at the same time.

Furthermore, also in the lithography using KrF excimer laser light, how to satisfy both high sensitivity and good defocus latitude depended on line pitch is an important problem, and this problem needs to be solved.

As regards the resist suitable for such a lithography process using KrF excimer laser light, electron beam or EUV light, a chemical amplification-type resist utilizing an acid catalytic reaction is mainly used from the standpoint of elevating the sensitivity and in the case of a positive resist, a chemical amplification-type resist composition mainly comprising an acid generator and a phenolic polymer which is insoluble or sparingly soluble in an alkali developer but becomes soluble in an alkali developer under the action of an acid (hereinafter simply referred to as a "phenolic acid-decomposable resin"), is being effectively used.

With respect to such a positive resist, there are known some resist compositions using a phenolic acid-decomposable resin obtained by copolymerizing an acid-decomposable acrylate monomer having an alicyclic group as the acid-decomposable group. Examples thereof include positive resist compositions disclosed in U.S. Patent 5,561,194, JP-A-2001-166474 (the term "JP-A" as used herein means an "unexamined published Japanese patent application"), JP-A-2001-166478, JP-A-2003-107708 and JP-A-2001-194792.

In JP-A-6-161111, a resist composition comprising a 4-tert-alkoxycarbonylmethylstyrene polymer and a radiation-sensitive acid generator is disclosed.

However, by any combination of these techniques, it is impossible at present in the ultrafine region to satisfy both high sensitivity and good defocus latitude depended on line pitch.

### Summary of the Invention

An object of the present invention is to solve the problems in the technology for enhancing the performance at the fine processing of a semiconductor device using actinic rays or radiation, particularly, KrF excimer laser light, electron beam or EUV light, and provide a resist composition capable of satisfying both high sensitivity and defocus latitude depended on line pitch and also excellent in terms of line width roughness and dissolution contrast, and a pattern forming method using the composition.

The present invention is as follows.
(1) A resist composition, comprising:
   (A) a resin that contains a repeating unit represented by formula (I); and
   (B) a compound capable of generating an acid upon irradiation with actinic rays or radiation: 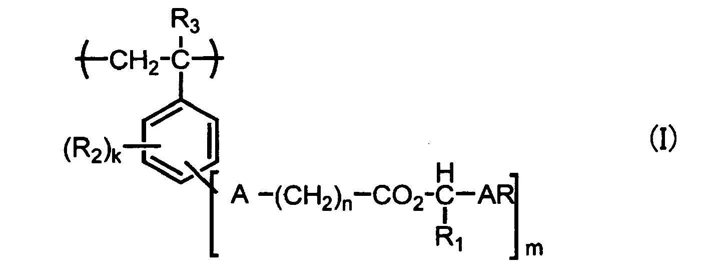
   wherein AR represents a phenyl group or a naphthyl group;
   R₁ represents an alkyl group, a cycloalkyl group or an aryl group;
   AR and R₁ may combine with each other to form a ring;
   R₂ represents, when a plurality of R₂s are present, each independently represents, a substituent;
   R₁ and R₂ may combine with each other to form a ring;
   R₃ represents a hydrogen atom, an alkyl group, a halogen atom, a cyano group or an alkyloxycarbonyl group;
   A represents a single bond or a divalent linking group;
   n represents an integer of 1 to 5;
   m represents an integer of 1 to 3; and
   k represents an integer of 0 to 3,
   provided that m and k satisfy m+k≤5.
(2) The resist composition as described in (1) above,
   wherein the resin as the component (A) further contains a repeating unit represented by formula (A1): 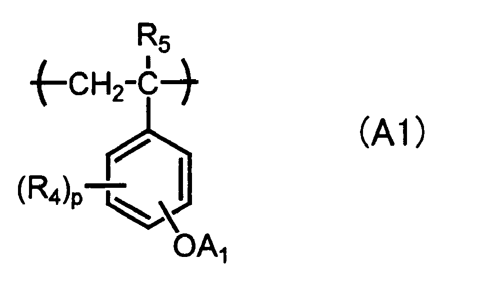 wherein A₁ represents a hydrogen atom or a group which leaves under an action of an acid;
   R₄ represents, when a plurality of R₄s are present, each independently represents, a substituent;
   R₅ represents a hydrogen atom, an alkyl group, a halogen atom, a cyano group or an alkyloxycarbonyl group; and
   p represents an integer of 0 to 3.
(3) The resist composition as described in (1) or (2) above,
   wherein the resin as the component (A) further contains a repeating unit represented by formula (A2): 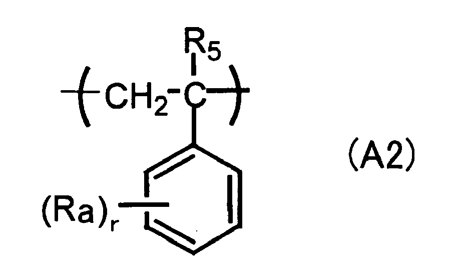 wherein Ra represents, when a plurality of Ra's are present, each independently represents, a substituent;
   R₅ represents a hydrogen atom, an alkyl group, a halogen atom, a cyano group or an alkyloxycarbonyl group; and
   r represents an integer of 0 to 5.
(4) The resist composition as described in any of (1) to (3) above,
   wherein the resin as the component (A) further contains a repeating unit containing a (meth)acrylic acid derivative incapable of decomposing under an action of an acid.
(5) The resist composition as described in any of (1) to (4) above,
   wherein a content of the repeating unit represented by formula (I) in the resin (A) is from 3 to 60 mol% based on all repeating units of the resin (A).
(6) The resist composition as described in any of (2) to (5) above,
   wherein a content of the repeating unit represented by formula (A1) in the resin (A) is from 40 to 97 mol% based on all repeating units of the resin (A).
(7) The resist composition as described in any of (1) to (6) above,
   wherein the resin (A) has a weight average molecular weight (Mw) of from 1,000 to 50,000.
(8) A pattern forming method, comprising:
   forming a resist film from the resist composition as described in any of (1) to (7) above; and
   exposing and developing the resist film.

### Detailed Description of the Invention

The best mode for carrying out the present invention is described in detail below.

Incidentally, in the present invention, when a group (atomic group) is denoted without specifying whether substituted or unsubstituted, the group includes both a group having no substituent and a group having a substituent. For example, an "alkyl group" includes not only an alkyl group having no substituent (unsubstituted alkyl group) but also an alkyl group having a substituent (substituted alkyl group).

The resist composition of the present invention comprises (A) a resin having a repeating unit represented by formula (I), and (B) a compound capable of generating an acid upon irradiation with actinic rays or radiation. (A) Resin having a repeating unit represented by formula (I)

The resist composition of the present invention comprises a resin having a repeating unit represented by the following formula (I) (hereinafter sometimes referred to as a "resin (A)").

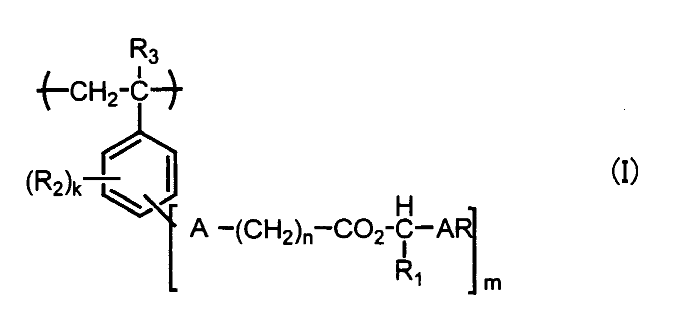

In formula (I), AR represents a phenyl group or a naphthyl group.

R₁ represents an alkyl group, a cycloalkyl group or an aryl group.

AR and R₁ may combine with each other to form a ring.

R₂ represents, when a plurality of R₂s are present, each independently represents, a substituent.

R₁ and R₂ may combine with each other to form a ring.

R₃ represents a hydrogen atom, an alkyl group, a halogen atom, a cyano group or an alkyloxycarbonyl group.

A represents a single bond or a divalent linking group.

n represents an integer of 1 to 5.

m represents an integer of 1 to 3.

k represents an integer of 0 to 3.

Here, m and k satisfy m+k≤5.

In formula (I), the phenyl group and naphthyl group of AR each may have a substituent. Examples of the substituent which the phenyl group and naphthyl group of AR may have include an alkyl group and an alkoxy group.

The alkyl group in R₁ includes a linear or branched alkyl group preferably having a carbon number of 1 to 20, such as methyl group, ethyl group, propyl group, isopropyl group, n-butyl group, isobutyl group, tert-butyl group, pentyl group, hexyl group, octyl group and dodecyl group.

The cycloalkyl group in R₁ includes a cycloalkyl group preferably having a carbon number of 3 to 20, such as cyclopropyl group, cyclobutyl group, cyclopentyl group and cyclohexyl group.

The aryl group in R₁ is preferably an aryl group having a carbon number of 6 to 14, such as phenyl group, xylyl group, toluyl group, cumenyl group, naphthyl group and anthracenyl group.

These groups each may have a substituent, and examples of the substituent which these groups each may have include an alkoxy group, a hydroxyl group, a halogen atom, a nitro group, an acyl group, an acyloxy group, an acylamino group, a sulfonylamino group, an alkylthio group, an arylthio group, an aralkylthio group, a thiophenecarbonyloxy group, a thiophenemethylcarbonyloxy group and a heterocyclic residue such as pyrrolidone residue. Among these, an alkoxy group, a hydroxyl group, a halogen atom, a nitro group, an acyl group, an acyloxy group, an acylamino group and a sulfonylamino group are more preferred.

The substituent as R₂ includes, for example, an alkyl group, an alkyloxy group, a halogen atom, an alkylcarbonyloxy group and an alkyloxycarbonyl group.

The alkyl group above includes a linear or branched alkyl group preferably having a carbon number of 1 to 20, such as methyl group, ethyl group, propyl group, isopropyl group, n-butyl group, isobutyl group, tert-butyl group, pentyl group, hexyl group, octyl group and dodecyl group.

The alkyloxy group includes a group where an oxy group is further bonded to the above-described alkyl group.

The halogen atom includes a fluorine atom, a chlorine atom, a bromine atom and an iodine atom and is preferably a hydrogen atom.

The alkylcarbonyloxy group is preferably an acetyl group.

The alkyloxycarbonyl group is preferably a methoxycarbonyl group or an ethoxycarbonyl group.

These groups each may have a substituent.

The alkyl group in R₃ includes a linear or branched alkyl group preferably having a carbon number of 1 to 20, such as methyl group, ethyl group, propyl group, isopropyl group, n-butyl group, isobutyl group, tert-butyl group, pentyl group, hexyl group, octyl group and dodecyl group. These groups each may have a substituent, and preferred examples of the substituent which these groups each may have include an alkoxy group, a hydroxyl group, a halogen atom, a nitro group, an acyl group, an acyloxy group, an acylamino group, a sulfonylamino group, an alkylthio group, an arylthio group, an aralkylthio group, a thiophenecarbonyloxy group, a thiophenemethylcarbonyloxy group and a heterocyclic residue such as pyrrolidone residue. Preferred examples of the alkyl group having a substituent include a CF₃ group, an alkyloxycarbonylmethyl group, an alkylcarbonyloxymethyl group, a hydroxymethyl group and an alkoxymethyl group.

The halogen atom in R₃ includes a fluorine atom, a chlorine atom, a bromine atom and an iodine atom and is preferably a hydrogen atom.

The alkyl contained in the alkyloxycarbonyl group in R₃ includes the same as the alkyl group above.

The divalent linking group represented by A is preferably an oxy group, a carbonyl group, -OCH(CH₃)OCH₂-, or a divalent linking group comprising a combination thereof.

The ring structure formed by combining AR and R₁ includes, for example, a 5- or 6-membered ring structure.

The ring structure formed by combining R₁ and R₂ includes, for example, a 6- or 7-membered ring structure.

At the time of forming a ring structure by combining R₁ and R₂, R₁ and R₂ may combine to form a single bond.

m is preferably 1, and a combination of m=1 and k=0 is more preferred.

The repeating unit represented by formula (I) is decomposed under the action of an acid to produce a carboxyl group and thereby increase the solubility in an alkali developer.

The monomer corresponding to the repeating unit represented by formula (I) can be synthesized by esterifying a carboxylmethylstyrene derivative of various types and a secondary alcohol compound in a solvent such as THF, acetone and methylene chloride in the presence of dicyclohexylcarbodiimide (DCC) as an esterifying agent. A commercially available product may also be used.

Specific examples of the repeating unit represented by formula (I) are set forth below, but the present invention is not limited thereto.

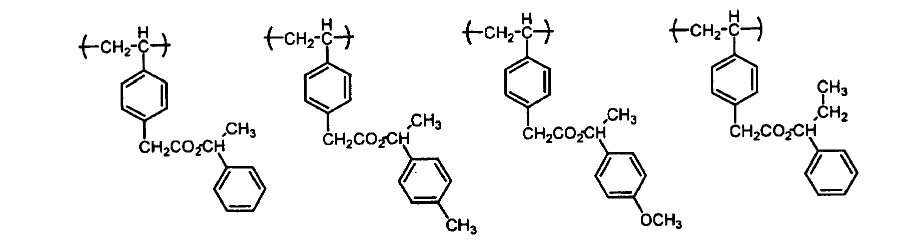

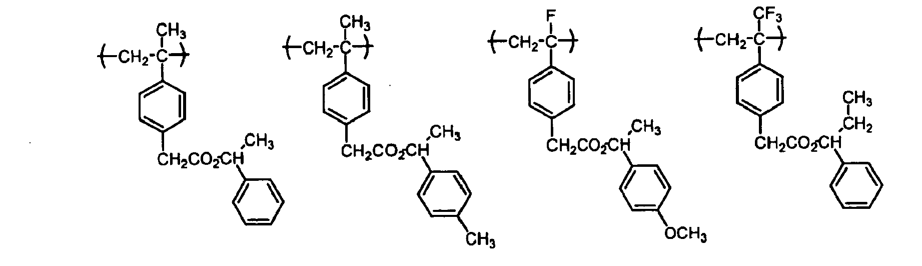

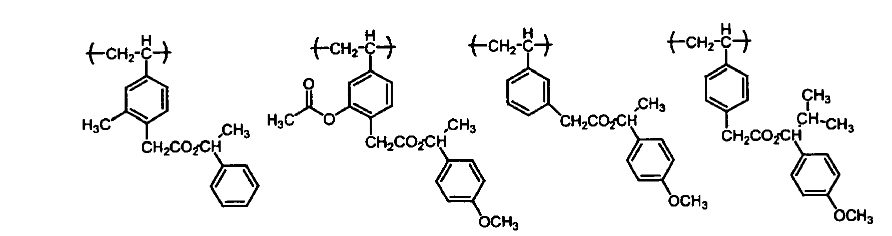

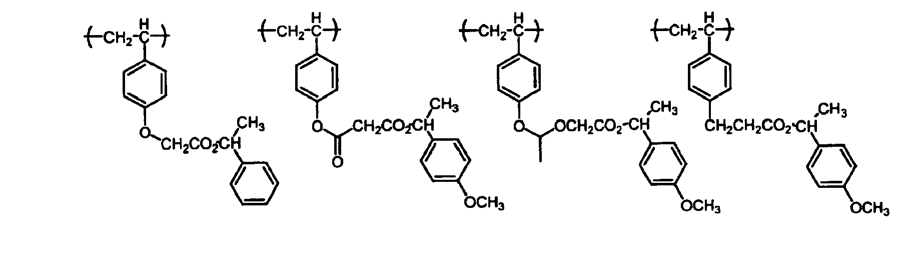

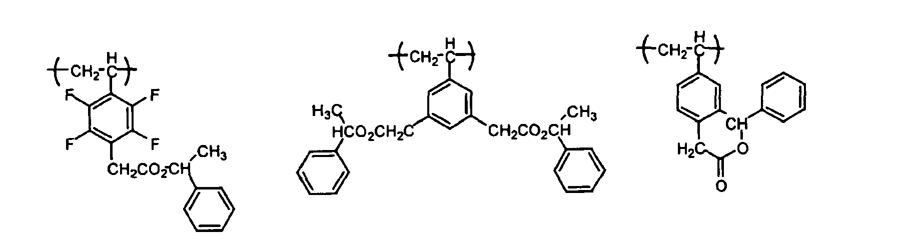

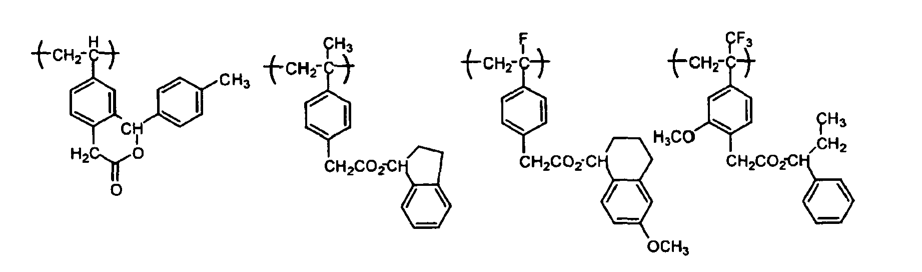

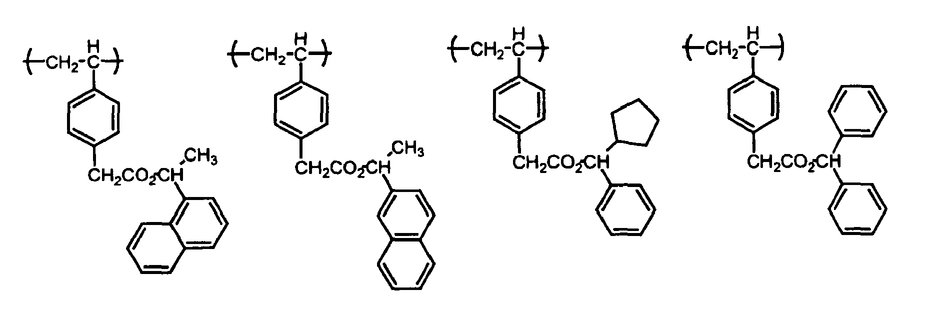

The resin (A) preferably further has a repeating unit represented by the following formula (A1).

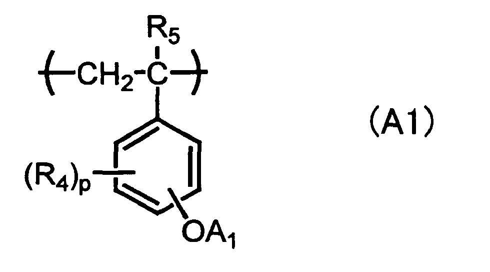

In formula (A1), A₁ represents a hydrogen atom or a group which leaves under the action of an acid.

R₄ represents, when a plurality of R₄s are present, each independently represents, a substituent.

R₅ represents a hydrogen atom, an alkyl group, a halogen atom, a cyano group or an alkyloxycarbonyl group.

p represents an integer of 0 to 3.

In formula (A1), the group which leaves under the action of an acid of A₁ includes, for example, a tertiary alkyl group such as tert-butyl group and tert-amyl group, a tert-butoxycarbonyl group, a tert-butoxycaronylmethyl group and an acetal group represented by -C(L₁)(L₂)-O-Z. Here, L₁ and L₂, which may be the same or different, each represents a hydrogen atom, an alkyl group, a cycloalkyl group or an aralkyl group, Z represents an alkyl group, a cycloalkyl group or an aralkyl group, and Z and L₁ may combine with each other to form a 5- or 6-membered ring.

The alkyl group of L₁, L₂ and Z is preferably a linear or branched alkyl group having a carbon number of 1 to 20, such as methyl group, ethyl group, propyl group, isopropyl group, n-butyl group, isobutyl group, tert-butyl group, pentyl group, hexyl group, octyl group and dodecyl group.

The cycloalkyl group of L₁, L₂ and Z is preferably a cycloalkyl group having a carbon number of 3 to 20, such as cyclopropyl group, cyclobutyl group, cyclopentyl group and cyclohexyl group.

The aralkyl group in L₁, L₂ and Z includes, for example, an aralkyl group having a carbon number of 7 to 15, such as benzyl group and phenethyl group.

These groups each may have a substituent, and preferred examples of the substituent which these groups each may have include an alkyl group, a cycloalkyl group, an aryl group, an alkoxy group, an aryloxy group, a hydroxyl group, a halogen atom, a nitro group, an acyl group, an acylamino group, a sulfonylamino group, an alkylthio group, an arylthio group and an aralkylthio group.

The 5- or 6-membered ring formed by combining Z and L₁ with each other includes, for example, a tetrahydropyran ring and a tetrahydrofuran ring.

Z is preferably a linear or branched alkyl group. By virtue of this construction, the effect of the present invention is brought out more prominently.

The substituent as R₄ includes, for example, an alkyl group, an alkoxy group, an alkoxycarbonyl group, an acyl group, an acyloxy group, a cycloalkyl group, an aryl group, an aryloxy group, an aralkyl group, an aralkyloxy group, a hydroxyl group, a halogen atom, a cyano group, a nitro group, a sufonylamino group, an alkylthio group, an arylthio group, an aralkylthio group, an alkylamido group, an arylamido group and an alkenyl group.

The alkyl group and the alkyl group in the alkoxy group, alkoxycarbonyl group, acyl group, acyloxy group, alkylthio group and alkylamido group each is preferably, for example, a linear or branched alkyl group having a carbon number of 1 to 20, such as methyl group, ethyl group, propyl group, isopropyl group, n-butyl group, isobutyl group, tert-butyl group, pentyl group, hexyl group, octyl group and dodecyl group.

The cycloalkyl group is preferably, for example, a cycloalkyl group having a carbon number of 3 to 20, such as cyclopropyl group, cyclobutyl group, cyclopentyl group and cyclohexyl group.

The aryl group and the aryl group in the aryloxy group, arylthio group and arylamido group each includes, for example, an aryl group having a carbon number of 6 to 14, such as phenyl group, xylyl group, toluyl group, cumenyl group, naphthyl group and anthracenyl group.

The aralkyl group and the aralkyl group in the aralkyloxy group and aralkylthio group each includes, for example, a benzyl group.

The alkenyl group is preferably, for example, an alkenyl group having a carbon number of 2 to 4, such as vinyl group, propenyl group, allyl group and butenyl group.

The substituent as R₄ may further have a substituent. Preferred examples of the substituent which R₄ may further have include an alkyl group, an alkoxy group, a hydroxyl group, a halogen atom, a nitro group, an acyl group, an acyloxy group, an acylamino group, a sulfonylamino group, an alkylthio group, an arylthio group, an aralkylthio group, an arylamido group, a thiophenecarbonyloxy group, a thiophenemethylcarbonyloxy group and a heterocyclic residue such as pyrrolidone residue.

R₅ has the same meaning as R₃ in formula (I).

The monomer corresponding to the repeating unit represented by formula (A1) may be synthesized by acetalizing a hydroxy-substituted styrene monomer and a vinyl ether compound in a solvent such as THF and methylene chloride in the presence of an acidic catalyst such as p-toluenesulfonic acid and pyridine p-toluenesulfonate, or by effecting tert-Boc protection using tert-butyl dicarboxylate in the presence of a basic catalyst such as triethylamine, pyridine and DBU. A commercially available product may also be used.

Specific examples of the repeating unit represented by formula (A1) are set forth below, but the present invention is not limited thereto.

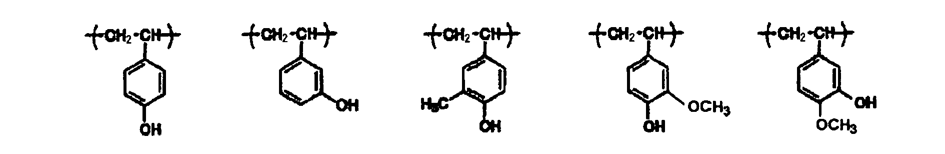

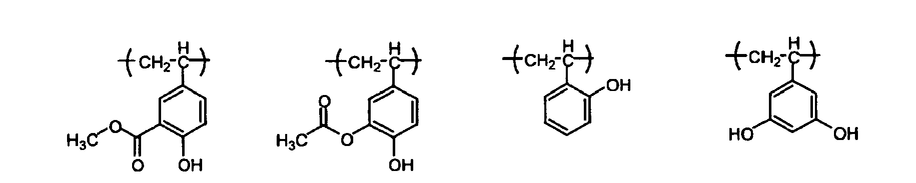

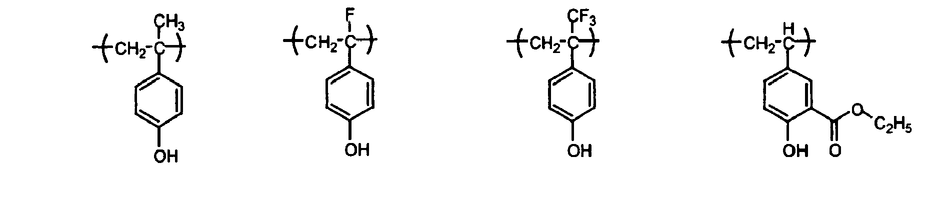

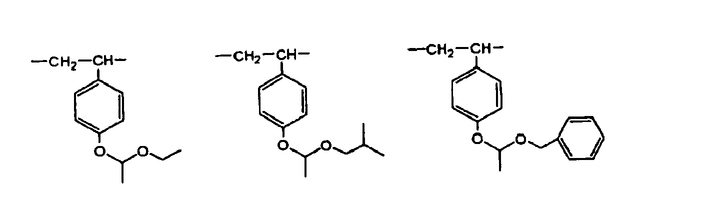

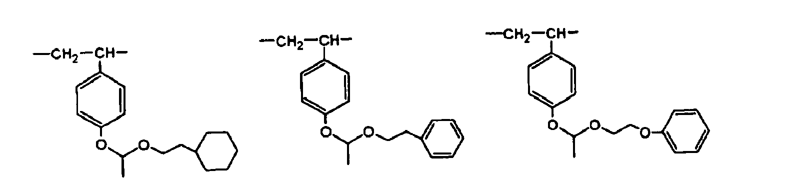

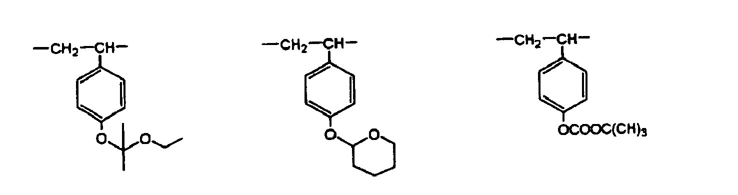

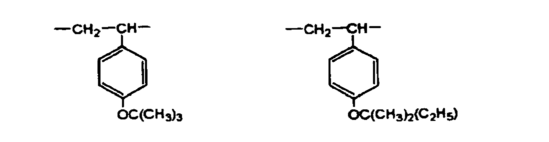

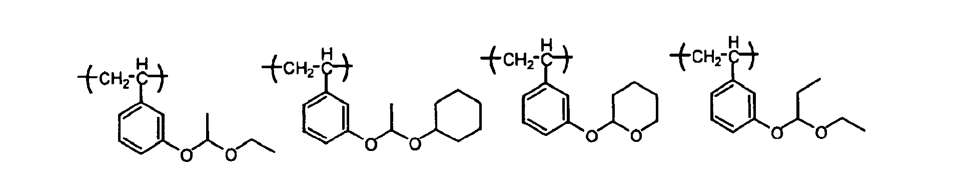

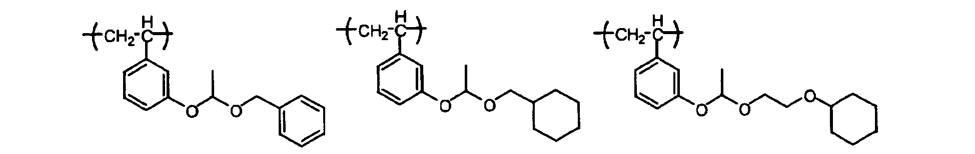

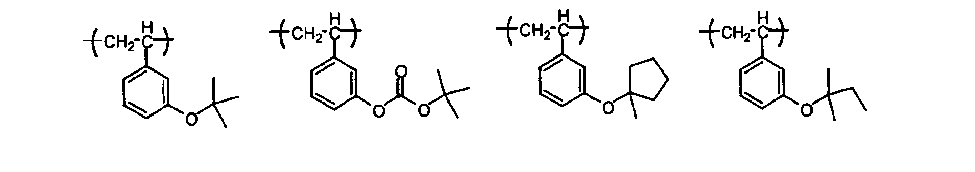

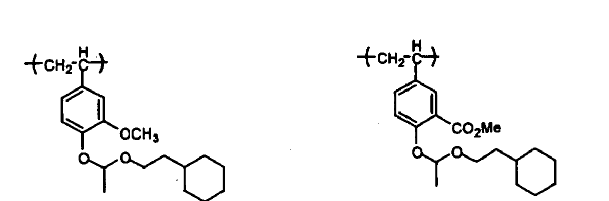

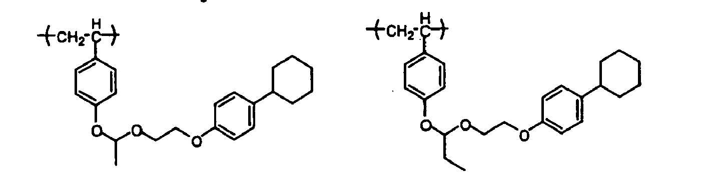

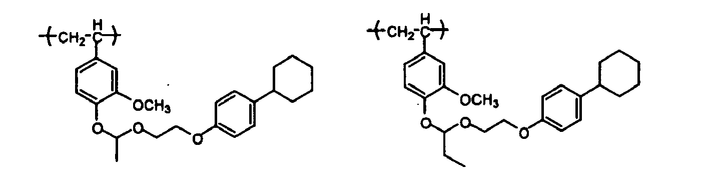

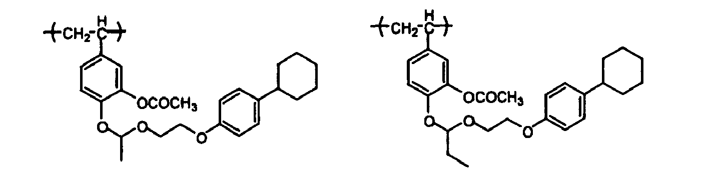

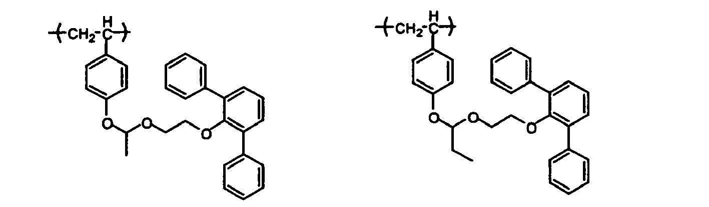

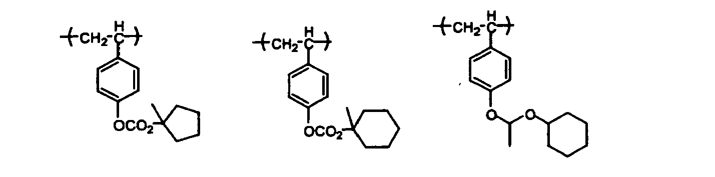

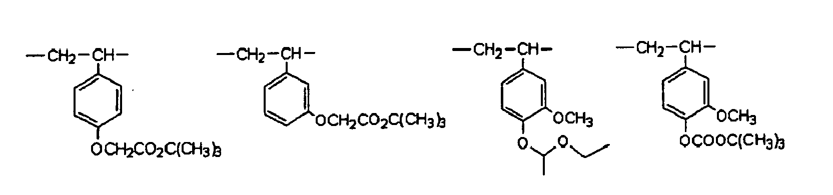

The resin (A) preferably further has a repeating unit represented by the following formula (A2).

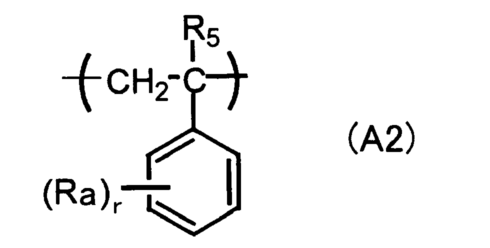

In formula (A2), Ra represents, when a plurality of Ra's are present, each independently represents, a substituent.

R₅ represents a hydrogen atom, an alkyl group, a halogen atom, a cyano group or an alkyloxycarbonyl group.

r represents an integer of 0 to 5.

In formula (A2), R₅ has the same meaning as R₅ in formula (A1).

The substituent as Ra includes, for example, an alkyl group, an alkoxy group, an alkoxycarbonyl group, an acyl group, an acyloxy group, a cycloalkyl group, an aryl group, an aryloxy group, an aralkyl group, an aralkyloxy group, a hydroxyl group, a halogen atom, a cyano group, a nitro group, a sufonylamino group, an alkylthio group, an arylthio group, an aralkylthio group, an alkylamido group, an arylamido group, an alkenyl group, an alkoxyalkoxy group, a cycloalkoxy group, a cycloalkoxycarbonyl group and an aryloxycarobnyl group.

In the substituent as Ra, the alkyl group and the alkyl group in the alkoxy group, alkoxycarbonyl group, alkylthio group, alkoxyalkoxy group and alkylamido group each is preferably an alkyl group having a carbon number of 1 to 4, such as methyl group, ethyl group, propyl group, n-butyl group, sec-butyl group and tert-butyl group; the cycloalkyl group and the cycloalkyl group in the cycloalkoxy group and cycloalkoxycarbonyl group each is preferably a cycloalkyl group having a carbon number of 3 to 10, such as cyclopropyl group, cyclobutyl group, cyclohexyl group and adamantyl group; the alkenyl group is preferably an alkenyl group having a carbon number of 2 to 4, such as vinyl group, propenyl group, allyl group and butenyl group; the aryl group and the aryl group in the aryloxy group, arylthio group, aryloxycarbonyl group and arylamido group each is preferably an aryl group having a carbon number of 6 to 14, such as phenyl group, xylyl group, toluyl group, cumenyl group, naphthyl group and anthracenyl group; the aralkyl group and the aralkyl group in the aralkyloxy group and aralkylthio group each is preferably an aralkyl group having a carbon number of 3 to 12, such as benzyl group, phenethyl group and naphthylmethyl group; and the acyl group and the acyl group in the acyloxy group each is preferably an acyl group having a carbon number of 1 to 8, such as formyl group, acetyl group, propionyl group, butyryl group, valeryl group, pivaloyl group and benzoyl group.

The substituent as Ra may further have a substituent. Preferred examples of the substituent which Ra may further have include an alkyl group, an alkoxy group, a hydroxyl group, a halogen atom, a nitro group, an acyl group, an acyloxy group, an acylamino group, a sulfonylamino group, an alkylthio group, an arylthio group, an aralkylthio group, an arylamido group, a thiophenecarbonyloxy group, a thiophenemethylcarbonyloxy group and a heterocyclic residue such as pyrrolidone residue.

Ra may be present at any position on the benzene ring but is preferably present at the meta- or para-position, more preferably at the para-position, of the styrene skeleton.

Specific examples of the repeating unit represented by formula (A2) are set forth below, but the present invention is not limited thereto.

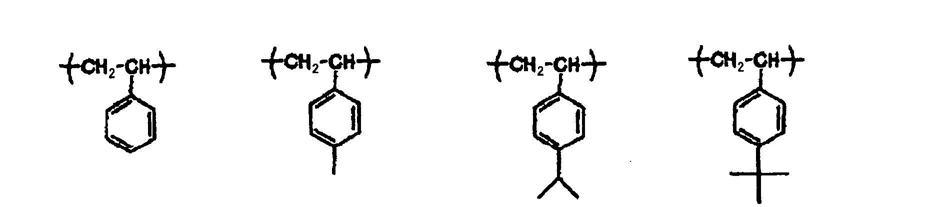

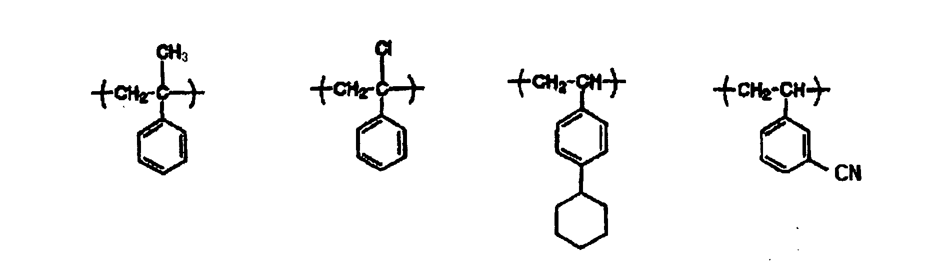

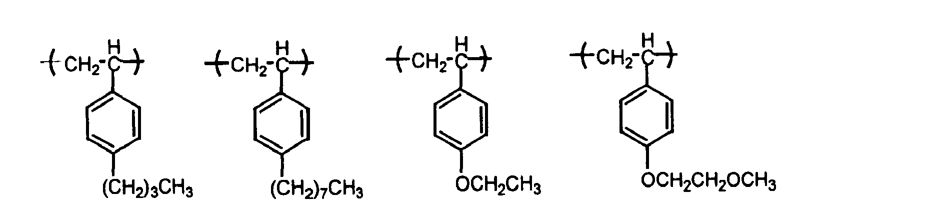

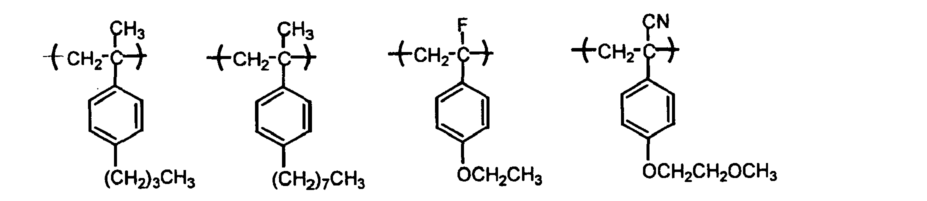

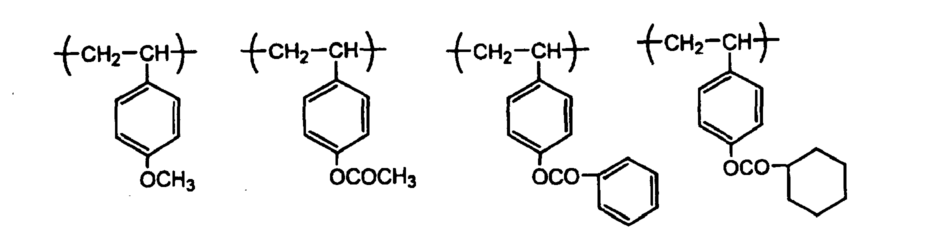

The resin (A) preferably further has a repeating unit comprising a (meth)acrylic acid derivative incapable of decomposing under the action of an acid.

Specific examples thereof are set forth below, but the present invention is not limited thereto.

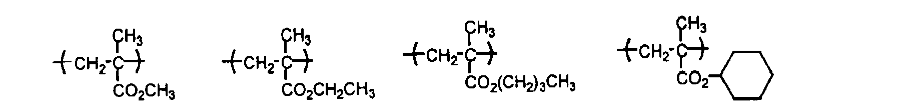

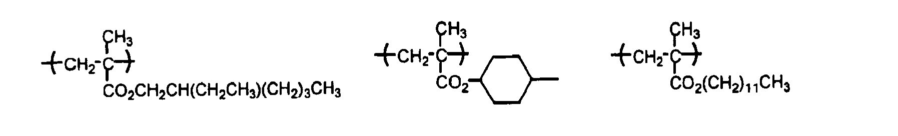

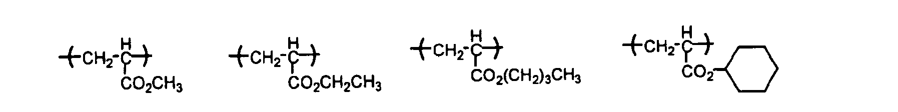

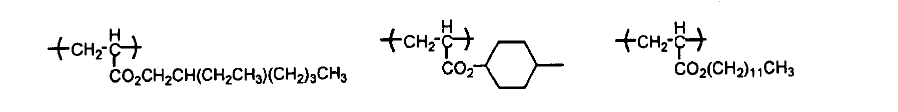

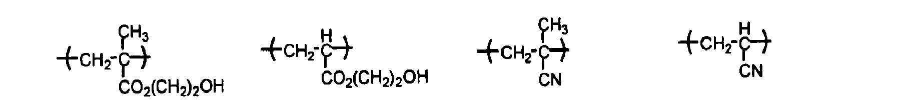

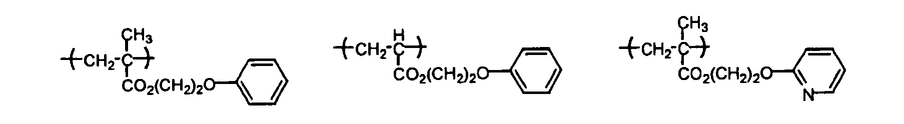

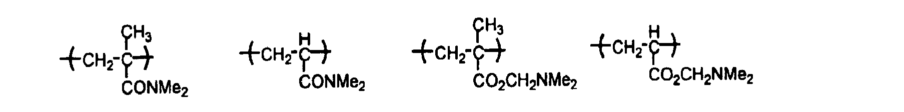

The resin (A) is a resin of which solubility in an alkali developer increases under the action of an acid (acid-decomposable resin), and contains, in an arbitrary repeating unit, a group capable of decomposing under the action of an acid to produce an alkali-soluble group (acid-decomposable group).

The resin (A) may contain the acid-decomposable group in the repeating unit represented by formula (I) and/or formula (A1) or in other repeating units.

Examples of the acid-decomposable group include a group represented by -C(=O)-X₁-R₀, in addition to the -CO₂-CH(R₁)AR group in the repeating unit represented by formula (I) and -OA₁ group in the repeating unit represented by formula (A1) (wherein A₁ represents a group which leaves under the action of an acid).

In the formula above, R₀ represents, for example, a tertiary alkyl group such as tert-butyl group and tert-amyl group, a 1-alkoxyethyl group such as isobornyl group, 1-ethoxyethyl group, 1-butoxyethyl group, 1-isobutoxyethyl group and 1-cyclohexyloxyethyl group, an alkoxymethyl group such as 1-methoxymethyl group and 1-ethoxymethyl group, a 3-oxoalkyl group, a tetrahydropyranyl group, a tetrahydrofuranyl group, a trialkylsilyl ester group, a 3-oxocyclohexyl ester group, a 2-methyl-2-adamantyl group or a mevalonic lactone group. X₁ represents an oxygen atom, a sulfur atom, -NH-, -NHSO₂- or - NHSO₂NH-.

The content of the repeating unit represented by formula (I) in the resin (A) is preferably from 3 to 60 mol%, more preferably from 5 to 50 mol%, still more preferably from 10 to 30 mol%, based on all repeating units.

The content of the repeating unit represented by formula (A1) in the resin (A) is preferably from 40 to 97 mol%, more preferably from 50 to 95 mol%, still more preferably from 60 to 90 mol%, based on all repeating units.

The content of the repeating unit having an acid-decomposable group in the resin (A) is preferably from 3 to 60 mol%, more preferably from 5 to 50 mol%, still more preferably from 10 to 40 mol%, based on all repeating units.

The resin (A) may further contain a repeating unit represented by formula (A2), and this is preferred, for example, from the standpoint of enhancing the film quality or suppressing the film loss in the unexposed area. The content of the repeating unit represented by formula (A2) is preferably from 0 to 50 mol%, more preferably from 0 to 40 mol%, still more preferably from 0 to 20 mol%, based on all repeating units.

In the resin (A), an appropriate other polymerizable monomer may be copolymerized to introduce an alkali-soluble group such as phenolic hydroxyl group and carboxyl group and thereby maintain good developability with an alkali developer, or a hydrophobic other polymerizable monomer such as alkyl acrylate and alkyl methacrylate may be copolymerized so as to enhance the film quality.

The resin (A) can be synthesized by an ordinary method (for example, radical polymerization). Examples of the synthesis method in general include a batch polymerization method of dissolving monomer species and an initiator in a solvent and heating the solution, thereby effecting the polymerization, and a dropping polymerization method of adding dropwise a solution containing monomer species and an initiator to a heated solvent over 1 to 10 hours. A dropping polymerization method is preferred. Examples of the reaction solvent include tetrahydrofuran, 1,4-dioxane, ethers such as diisopropyl ether, ketones such as methyl ethyl ketone and methyl isobutyl ketone, an ester solvent such as ethyl acetate, an amide solvent such as dimethylformamide and dimethylacetamide, and a solvent capable of dissolving the composition of the present invention, which is described later, such as propylene glycol monomethyl ether acetate, propylene glycol monomethyl ether and cyclohexanone. The polymerization is more preferably performed using the same solvent as the solvent used in the resist composition of the present invention. By the use of this solvent, production of particles during storage can be suppressed.

The polymerization reaction is preferably performed in an inert gas atmosphere such as nitrogen and argon. As for the polymerization initiator, the polymerization is started using a commercially available radical initiator (e.g., azo-based initiator, peroxide). The radical initiator is preferably an azo-based initiator, and an azo-based initiator having an ester group, a cyano group or a carboxyl group is preferred. Preferred examples of the initiator include azobisisobutyronitrile, azobisdimethylvaleronitrile and dimethyl 2,2'-azobis(2-methylpropionate). The initiator is added additionally or in parts, if desired. After the completion of reaction, the reactant is charged into a solvent, and the desired polymer is recovered by a method such as powder or solid recovery. The reaction concentration is from 5 to 50 mass%, preferably from 10 to 30 mass%, and the reaction temperature is usually from 10 to 150°C, preferably from 30 to 120°C, more preferably from 60 to 100°C. (In this specification, mass ratio is equal to weight ratio.)

The weight average molecular weight (Mw) of the resin (A) is preferably from 1,000 to 50,000, more preferably from 3,000 to 20,000. The weight average molecular weight here is defined as a polystyrene-reduced value determined by gel permeation chromatography. The dispersity (Mw/Mn) is preferably from 1.0 to 2.0, more preferably from 1.0 to 1.8, still more preferably from 1.0 to 1.5. The resin (A) having a dispersity of 1.5 to 2.0 can be synthesized by radical polymerization using an azo-based polymerization initiator. Also, the resin (A) having a still more preferred dispersity of 1.0 to 1.2 can be synthesized by living radical polymerization.

Two or more species of the resin (A) may be used in combination.

The amount of the resin (A) added is, as the total amount, usually from 10 to 96 mass%, preferably from 15 to 96 mass%, more preferably from 20 to 95 mass%, based on the entire solid content of the resist composition.

Specific examples of the (A) resin are set forth below, but the present invention is not limited thereto. 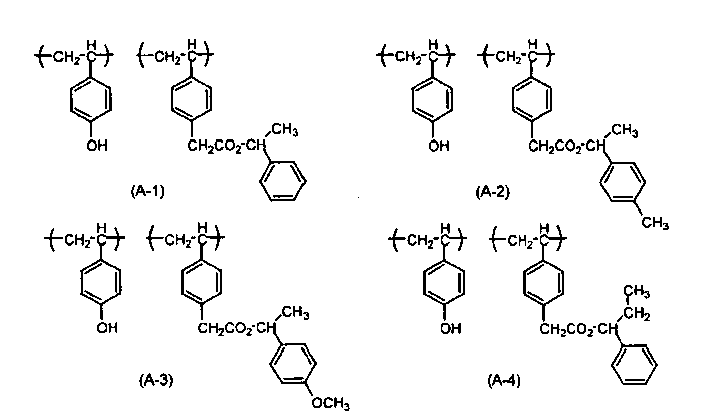 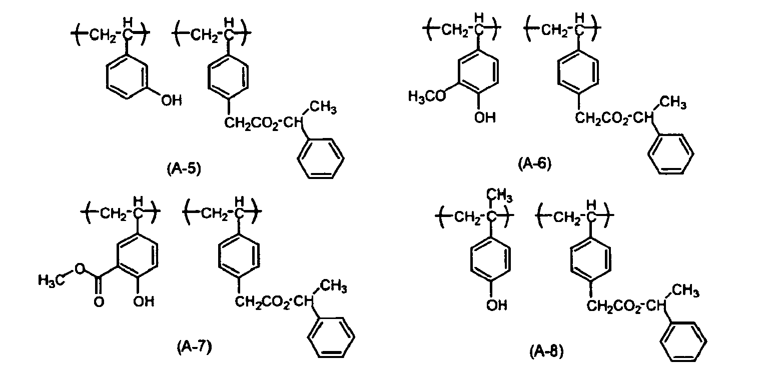 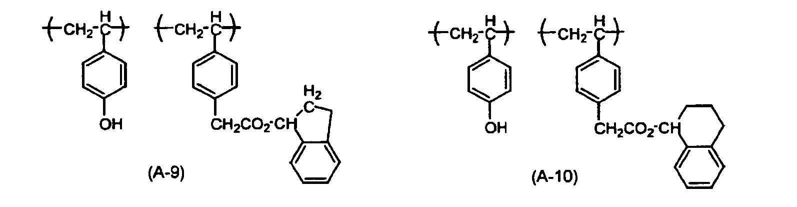 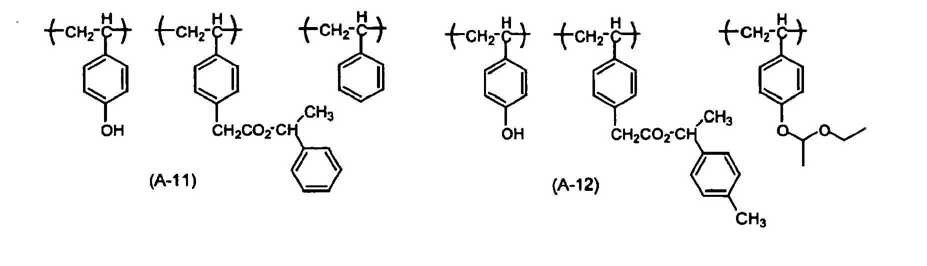 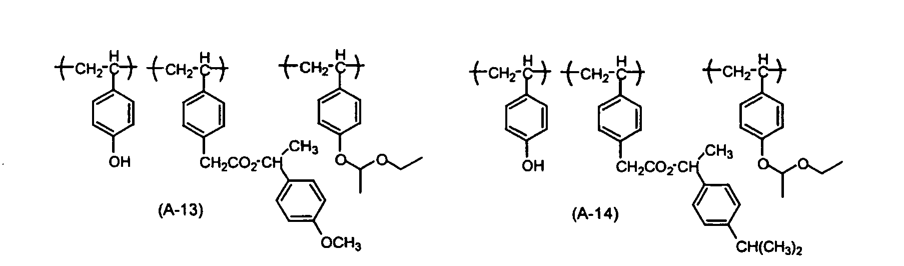 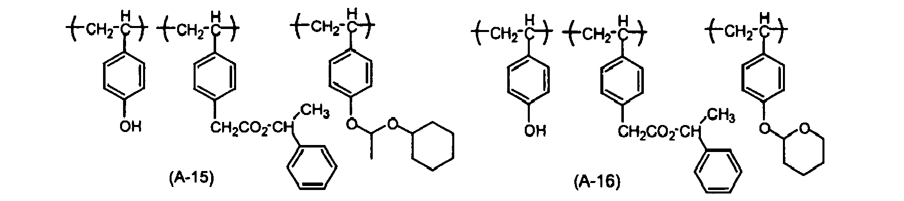 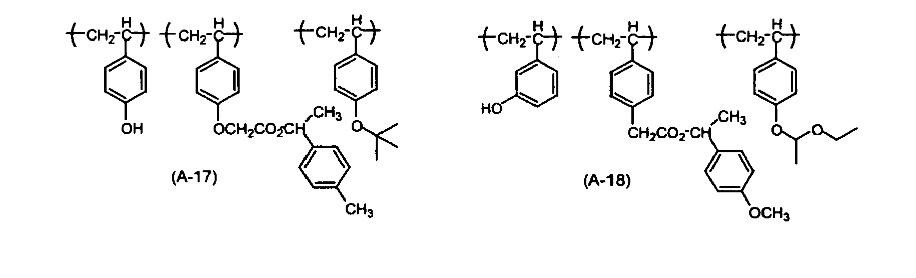 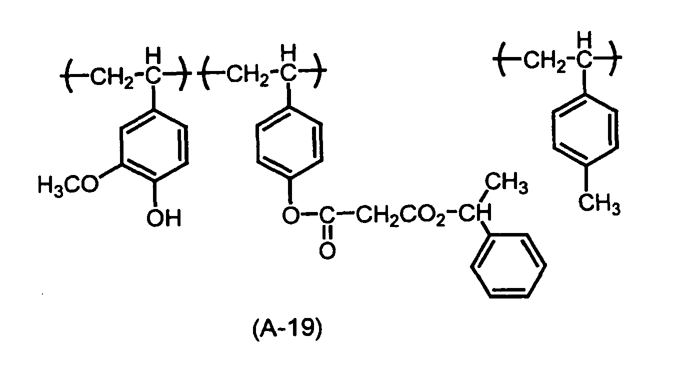 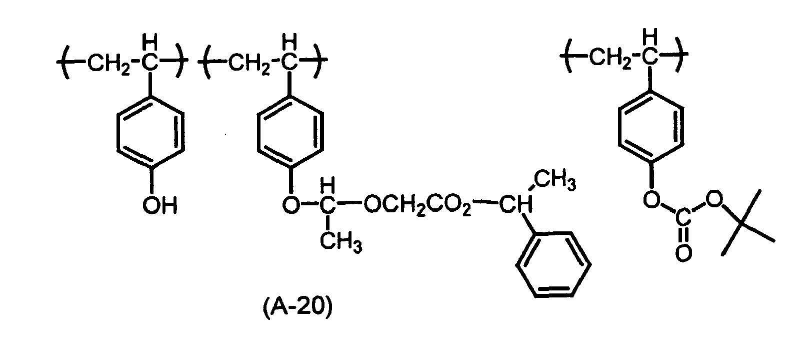 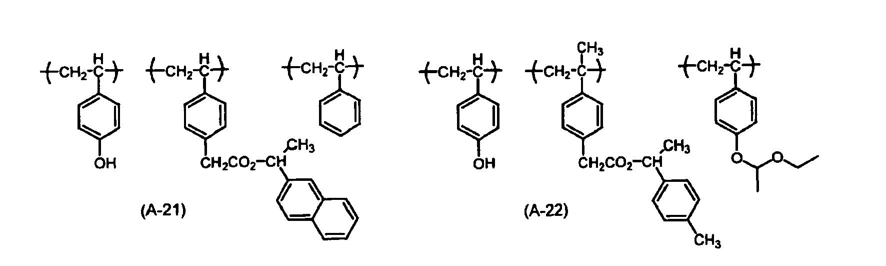 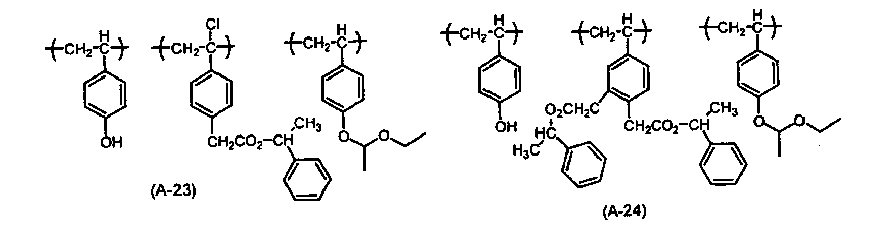 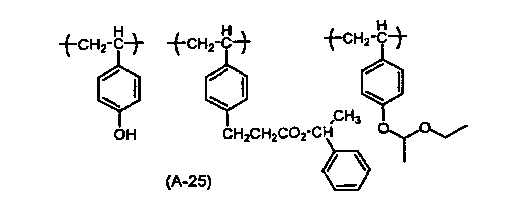 (B) Compound capable of generating acid upon irradiation with actinic rays or radiation

In the resist composition of the present invention, a known compound may be used as the compound capable of generating an acid upon irradiation with actinic rays or radiation (acid generator), but a compound capable of generating a sulfonic acid upon irradiation with actinic rays or radiation (sulfonic acid generator) and/or a compound capable of generating a carboxylic acid upon irradiation with actinic rays or radiation (carboxylic acid generator) are preferably contained.

### Compound capable of generating sulfonic acid upon irradiation with actinic rays or radiation:

The compound capable of generating a sulfonic acid upon irradiation with actinic rays or radiation (sometimes referred to as a "sulfonic acid generator"), contained in the resist composition of the present invention, is a compound capable of generating a sulfonic acid upon irradiation with actinic rays or radiation such as KrF excimer laser, electron beam and EUV, and examples thereof include a diazonium salt, a phosphonium salt, a sulfonium salt, an iodonium salt, an imidosulfonate, an oxime sulfonate, a diazodisulfone, a disulfone and an o-nitrobenzylsulfonate.

Also, a compound where such a group or compound capable of generating a sulfonic acid upon irradiation with actinic rays or radiation is introduced into the main or side chain of a polymer may be used, and examples thereof include compounds described in U.S. Patent 3,849,137, German Patent 3,914,407, JP-A-63-26653, JP-A-55-164824, JP-A-62-69263, JP-A-63-146038, JP-A-63-163452, JP-A-62-153853 and JP-A-63-146029.

Furthermore, compounds capable of generating a sulfonic acid by the effect of light described, for example, in U.S. Patent 3,779,778 and European Patent 126,712 may also be used.

In the present invention, from the standpoint of enhancing the resolving power and image performance such as pattern profile, a sulfonium salt, an iodonium salt, an imidosulfonate, an oxime sulfonate, a diazodisulfone and a disulfone are preferred as the sulfonic acid generator.

Out of the sulfonic acid generators, the compounds represented by the following formulae (ZI), (ZII) and (ZIII) are preferred.

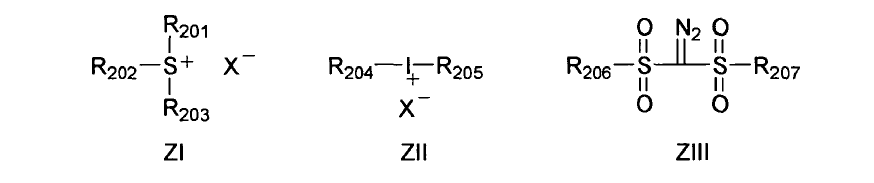

In formula (ZI), R₂₀₁, R₂₀₂ and R₂₀₃ each independently represents an organic group. Two members out of R₂₀₁ to R₂₀₃ may combine to form a ring structure.

X⁻ represents an organic sulfonate anion.

The number of carbons in the organic group as R₂₀₁, R₂₀₂ and R₂₀₃ is generally from 1 to 30, preferably from 1 to 20.

Examples of the group formed by combining two members out of R₂₀₁ to R₂₀₃ include an alkylene group (e.g., butylene, pentylene), and the ring may contain an oxygen atom, a sulfur atom, an ester bond, an amide bond or a carbonyl group.

Specific examples of the organic group as R₂₀₁, R₂₀₂ and R₂₀₃ include corresponding groups in the compounds (ZI-1), (ZI-2) and (ZI-3) which are described later.

The compound may be a compound having a plurality of structures represented by formula (ZI), for example, may be a compound having a structure where at least one of R₂₀₁ to R₂₀₃ in the compound represented by formula (ZI) is bonded to at least one of R₂₀₁ to R₂₀₃ in another compound represented by formula (ZI).

The component (ZI) is more preferably a compound (ZI-1), (ZI-2) or (ZI-3) described below.

The compound (ZI-1) is an arylsulfonium compound where at least one of R₂₀₁ to R₂₀₃ in formula (ZI) is an aryl group, that is, a compound having an arylsulfonium as the cation.

In the arylsulfonium compound, R₂₀₁ to R₂₀₃ all may be an aryl group or a part of R₂₀₁ to R₂₀₃ may be an aryl group with the remaining being an alkyl group or a cycloalkyl group.

Examples of the arylsulfonium compound include a triarylsulfonium compound, a diarylalkylsulfonium compound, an aryldialkylsulfonium compound, a diarylcycloalkylsulfonium compound and an aryldicycloalkylsulfonium compound.

The aryl group in the arylsulfonium compound includes an aryl group composed of hydrocarbon and a heteroaryl group having a heteroatom such as nitrogen atom, sulfur atom and oxygen atom. The aryl group composed of hydrocarbon is preferably a phenyl group or a naphthyl group, more preferably a phenyl group. Examples of the heteroaryl group include a pyrrole group, an indole group, a carbazole group, a furan group and a thiophene group, with an indole group being preferred. In the case where the arylsulfonium compound has two or more aryl groups, these two or more aryl groups may be the same of different.

The alkyl group which is present, if desired, in the arylsulfonium compound is preferably a linear or branched alkyl group having a carbon number of 1 to 15, and examples thereof include a methyl group, an ethyl group, a propyl group, an n-butyl group, a sec-butyl group and a tert-butyl group.

The cycloalkyl group which is present, if desired, in the arylsulfonium compound is preferably a cycloalkyl group having a carbon number of 3 to 15, and examples thereof include a cyclopropyl group, a cyclobutyl group and a cyclohexyl group.

The aryl group, alkyl group and cycloalkyl group of R₂₀₁ to R₂₀₃ each may have, as the substituent, an alkyl group (for example, an alkyl group having a carbon number of 1 to 15), a cycloalkyl group (for example, a cycloalkyl group having a carbon number of 3 to 15), an aryl group (for example, an aryl group having a carbon number of 6 to 14), an alkoxy group (for example, an alkoxy group having a carbon number of 1 to 15), a halogen atom, a hydroxyl group, a phenylthio group, or the like. The substituent is preferably a linear or branched alkyl group having a carbon number of 1 to 12, a cycloalkyl group having a carbon number of 3 to 12, or an alkoxy group having a carbon number of 1 to 12, more preferably an alkyl group having a carbon number of 1 to 4, or an alkoxy group having a carbon number of 1 to 4. The substituent may be substituted to any one of three members R₂₀₁ to R₂₀₃ or may be substituted to all of these three members. In the case where R₂₀₁ to R₂₀₃ are an aryl group, the substituent is preferably substituted at the p-position of the aryl group.

Examples of the organic sulfonate anion of X⁻ include aliphatic sulfonate anion, aromatic sulfonate anion and camphorsulfonate anion.

Examples of the aliphatic group in the aliphatic sulfonate anion include an alkyl group having a carbon number of 1 to 30, such as methyl group, ethyl group, propyl group, isopropyl group, n-butyl group, isobutyl group, sec-butyl group, pentyl group, neopentyl group, hexyl group, heptyl group, octyl group, nonyl group, decyl group, undecyl group, dodecyl group, tridecyl group, tetradecyl group, pentadecyl group, hexadecyl group, heptadecyl group, octadecyl group, nonadecyl group and eicosyl group, and a cycloalkyl group having a carbon number of 3 to 30, such as cyclopropyl group, cyclopentyl group, cyclohexyl group, adamantyl group, norbornyl group and boronyl group.

The aromatic group in the aromatic sulfonate anion is preferably an aryl group having a carbon number of 6 to 14, such as phenyl group, tolyl group and naphthyl group.

The alkyl group, cycloalkyl group and aryl group in the aliphatic sulfonate anion and aromatic sulfonate anion each may have a substituent.

Examples of the substituent include a nitro group, a halogen atom (e.g., fluorine, chlorine, bromine, iodine), a carboxyl group, a hydroxyl group, an amino group, a cyano group, an alkoxy group (preferably having a carbon number of 1 to 5), a cycloalkyl group (preferably having a carbon number of 3 to 15), an aryl group (preferably having a carbon number of 6 to 14), an alkoxycarbonyl group (preferably having a carbon number of 2 to 7), an acyl group (preferably having a carbon number of 2 to 12), an alkoxycarbonyloxy group (preferably having a carbon number of 2 to 7) and an alkylthio group (preferably having a carbon number of 1 to 15). As for the aryl group and ring structure in each group, examples of the substituent further include an alkyl group (preferably having a carbon number of 1 to 15).

The organic sulfonate anion of X⁻ is preferably an aliphatic sulfonate anion with the α-position of the sulfonic acid being substituted by a fluorine atom, or an aromatic sulfonate anion substituted by a fluorine atom or a fluorine atom-containing group. The organic sulfonate anion is more preferably a perfluoro aliphatic sulfonate anion having a carbon number of 4 to 8, or an aromatic sulfonate anion having a fluorine atom, still more preferably nonafluorobutanesulfonate anion, perfluorooctanesulfonate anion, pentafluorobenzenesulfonate anion or 3,5-bis(trifluoromethyl)benzenesulfonate anion.

The compound (ZI-2) is described below.

The compound (ZI-2) is a compound where R₂₀₁ to R₂₀₃ in formula (ZI) each independently represents an aromatic ring-free organic group.

The aromatic ring-free organic group as R₂₀₁ to R₂₀₃ generally has a carbon number of 1 to 30, preferably from 1 to 20.

R₂₀₁ to R₂₀₃ each independently represents preferably an alkyl group, a cycloalkyl group, an allyl group or a vinyl group, more preferably a linear, branched or cyclic 2-oxoalkyl group or an alkoxycarbonylmethyl group, and most preferably a linear or branched 2-oxoalkyl group.

The alkyl group of R₂₀₁ to R₂₀₃ may be linear or branched and is preferably a linear or branched alkyl group having a carbon number of 1 to 10, and examples thereof include a methyl group, an ethyl group, a propyl group, a butyl group and a pentyl group. The alkyl group is more preferably a linear or branched 2-oxoalkyl group or an alkoxycarbonylmethyl group.

The cycloalkyl group of R₂₀₁ to R₂₀₃ is preferably a cycloalkyl group having a carbon number of 3 to 10, and examples thereof include a cyclopentyl group, a cyclohexyl group and a norbornyl group. The cycloalkyl group is more preferably a cyclic 2-oxoalkyl group.

The 2-oxoalkyl group may be linear, branched or cyclic and is preferably a group having >C=O at the 2-position of the above-described alkyl or cycloalkyl group.

The alkyl group in the alkoxycarbonylmethyl group is preferably an alkyl group having a carbon number of 1 to 5 (e.g., methyl, ethyl, propyl, butyl, pentyl).

R₂₀₁ to R₂₀₃ each may be further substituted by a halogen atom, an alkoxy group (for example, an alkoxy group having a carbon number of 1 to 5), a hydroxyl group, a cyano group or a nitro group.

The compound (ZI-3) is a compound represented by the following formula (ZI-3), and this is a compound having a phenacylsulfonium salt structure.

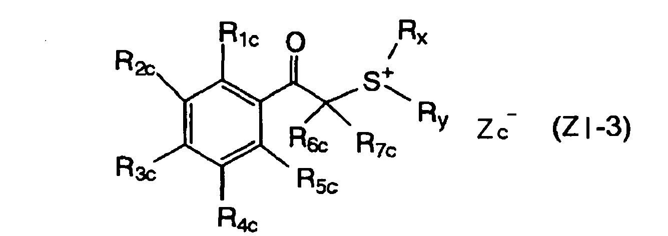

In formula (ZI-3), R_{1c} to R_{5c} each independently represents a hydrogen atom, an alkyl group, a cycloalkyl group, an alkoxy group or a halogen atom.

R_{6c} and R_{7c} each represents a hydrogen atom, an alkyl group or a cycloalkyl group.

Rₓ and R_{y} each independently represents an alkyl group, a cycloalkyl group, an allyl group or a vinyl group.

Any two or more members out of R_{1c} to R_{7c} or the pair of Rₓ and R_{y} may combine with each other to form a ring structure, and the ring structure may contain an oxygen atom, a sulfur atom, an ester bond or an amide bond.

Zc⁻ represents an organic sulfonate anion, and examples thereof are the same as those of the organic sulfonate anion of X⁻ in formula (ZI).

The alkyl group as R_{1c} to R_{7c} is preferably a linear or branched alkyl group having a carbon number of 1 to 20, and examples thereof include a methyl group, an ethyl group, a linear or branched propyl group, a linear or branched butyl group, and a linear or branched pentyl group.

The cycloalkyl group as R_{1c} to R_{7c} is preferably a cycloalkyl group having a carbon number of 3 to 8, and examples thereof include a cyclopentyl group and a cyclohexyl group.

The alkoxy group as R_{1c} to R_{5c} may be linear, branched or cyclic and is, for example, an alkoxy group having a carbon number of 1 to 10, preferably a linear or branched alkoxy group having a carbon number of 1 to 5 (e.g., methoxy, ethoxy, linear or branched propoxy, linear or branched butoxy, linear or branched pentoxy) or a cyclic alkoxy group having a carbon number of 3 to 8 (e.g., cyclopentyloxy, cyclohexyloxy).

A compound where any one of R_{1c} to R_{5c} is a linear or branched alkyl group, a cycloalkyl group or a linear, branched or cyclic alkoxy group is preferred, and a compound where the sum of carbon atoms of R_{1c} to R_{5c} is from 2 to 15 is more preferred. In this case, the solubility in a solvent is more enhanced and the generation of particles during storage is suppressed.

Examples of the alkyl group and cycloalkyl group as Rₓ and R_{y} are the same as those of the alkyl group and cycloalkyl group of R_{1c} to R_{7c}. Among these, a 2-oxoalkyl group and an alkoxycarbonylmethyl group are preferred.

Examples of the 2-oxoalkyl group include a group having >C=O at the 2-position of the alkyl or cycloalkyl group of R_{1c} to R_{7c}.

Examples of the alkoxy group in the alkoxycarbonylmethyl group are the same as those of the alkoxy group of R_{1c} to R_{5c}.

Examples of the group formed by combining any two or more members out of R_{1c} to R_{7c} or the pair of Rₓ and R_{y} include a butylene group and a pentylene group.

Rₓ and R_{y} each is preferably an alkyl group having a carbon number of 4 or more, more preferably 6 or more, still more preferably 8 or more.

In formulae (ZII) and (ZIII), R₂₀₄ to R₂₀₇ each independently represents an aryl group, an alkyl group or a cycloalkyl group.

The aryl group of R₂₀₄ to R₂₀₇ includes an aryl group composed of hydrocarbon, and an aryl group having a heteroatom such as nitrogen atom, sulfur atom and oxygen atom. The aryl group composed of hydrocarbon is preferably a phenyl group or a naphthyl group, more preferably a phenyl group. Examples of the heteroaryl group include a pyrrole group, an indole group, a carbazole group, a furan group and a thiophene group, with an indole group being preferred.

The alkyl group of R₂₀₄ to R₂₀₇ is preferably a linear or branched alkyl group having a carbon number of 1 to 10, and examples thereof include a methyl group, an ethyl group, a propyl group, a butyl group and a pentyl group.

The cycloalkyl group of R₂₀₄ to R₂₀₇ is preferably a cycloalkyl group having a carbon number of 3 to 10, and examples thereof include a cyclopentyl group, a cyclohexyl group and a norbornyl group.

Examples of the substituent which R₂₀₄ to R₂₀₇ each may have include an alkyl group (for example, an alkyl group having a carbon number of 1 to 15), a cycloalkyl group (for example, a cycloalkyl group having a carbon number of 3 to 15), an aryl group (for example, an aryl group having a carbon number of 6 to 15), an alkoxy group (for example, an alkoxy group having a carbon number of 1 to 15), a halogen atom, a hydroxyl group and a phenylthio group.

X⁻ represents an organic sulfonate anion, and examples thereof are the same as those of the organic sulfonate anion of X⁻ in formula (ZI).

The preferred sulfonic acid generator further includes compounds represented by the following formulae (ZIV), (ZV) and (ZVI).

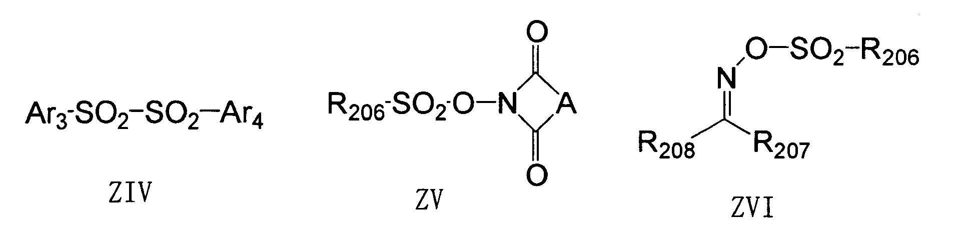

In formulae (ZIV) to (ZVI), Ar₃ and Ar₄ each independently represents an aryl group.

R₂₀₆, R₂₀₇ and R₂₀₈ each represents an alkyl group, a cycloalkyl group or an aryl group.

A represents an alkylene group, an alkenylene group or an arylene group.

The preferred sulfonic acid generator further includes a compound represented by the following formula (ZVII).

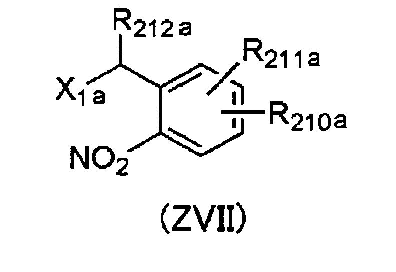

In formula (ZVII), R₂₁₀ₐ and R₂₁₁ₐ each independently represents a hydrogen atom, an alkyl group, a cycloalkyl group, a cyano group, a nitro group or an alkoxycarbonyl group and is preferably a halogen-substituted alkyl or cycloalkyl group, a nitro group or a cyano group.

R₂₁₂ₐ represents a hydrogen atom, an alkyl group, a cycloalkyl group, a cyano group or an alkoxycarbonyl group.

X₁ₐ represents a monovalent group resulting from removal of the hydrogen atom of -SO₃H of an organic sulfonic acid.

The preferred sulfonic acid generator further includes a compound represented by the following formula (ZVIII).

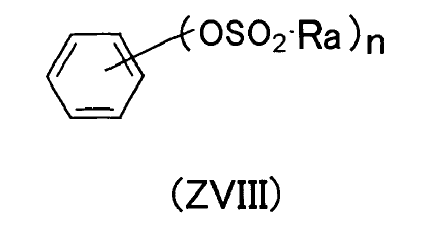

In formula (ZVIII), Ra represents an alkyl group, a cycloalkyl group or an aryl group. In the case where a plurality of Ra's are present, the plurality of Ra's may be the same or different.

n represents an integer of 1 to 6.

Specific examples of the sulfonic acid generator are set forth below, but the present invention is not limited thereto.

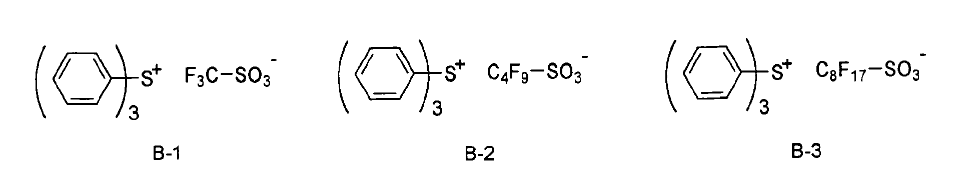

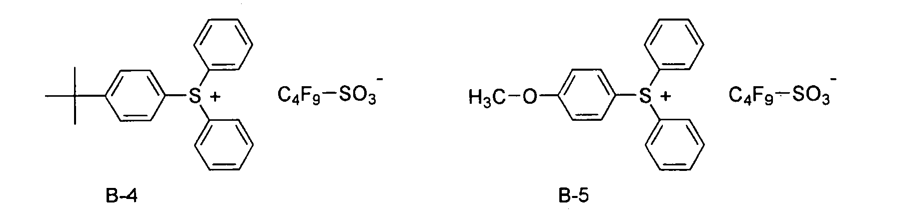

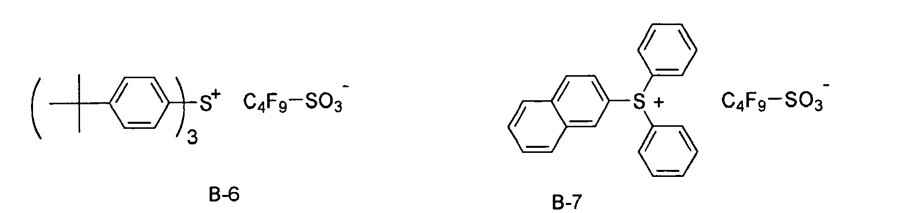

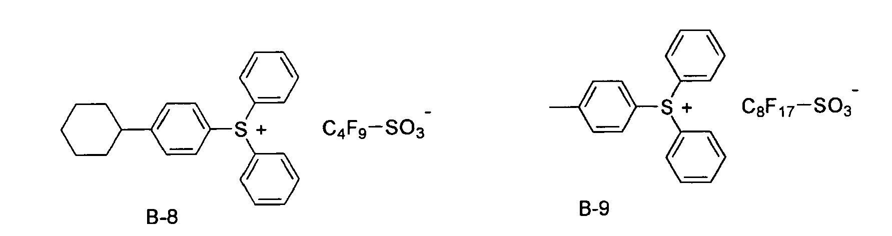

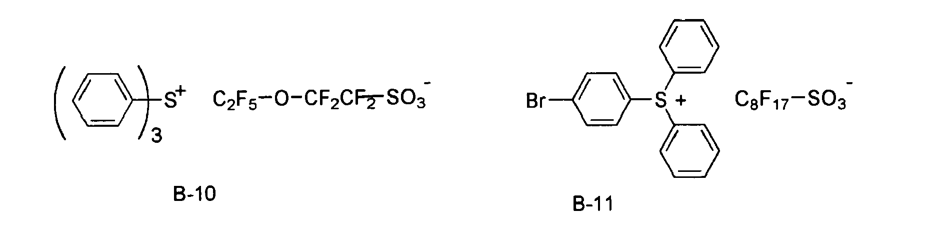

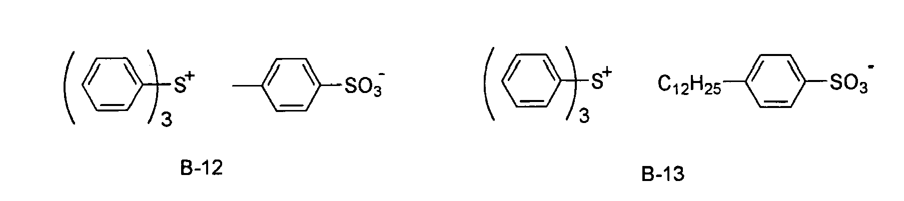

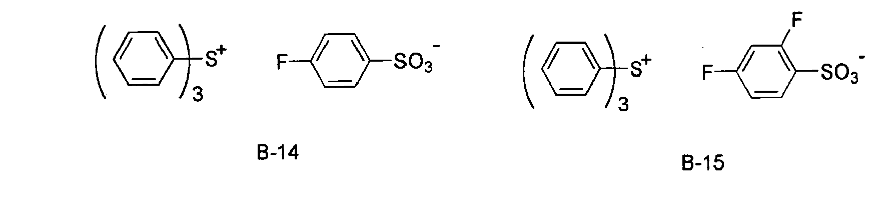

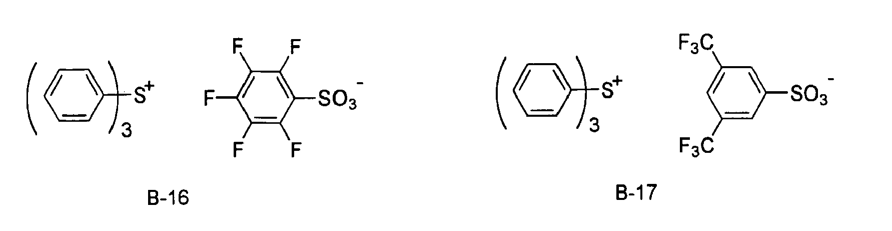

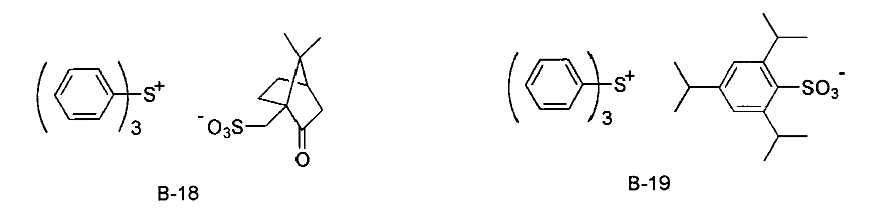

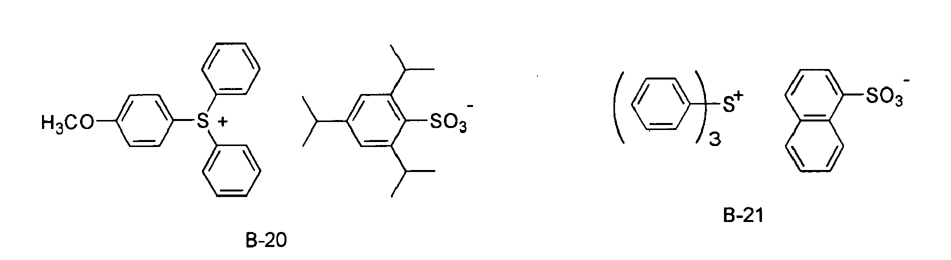

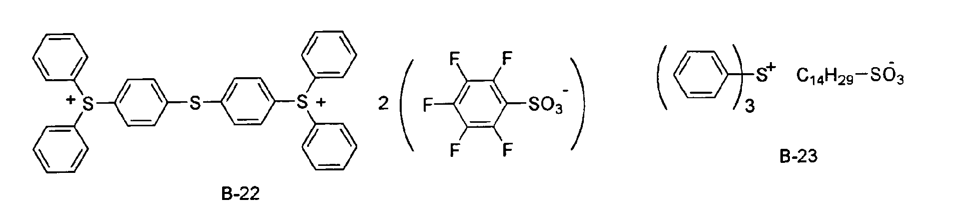

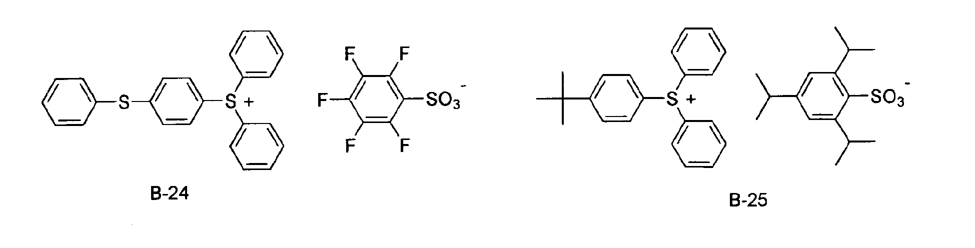

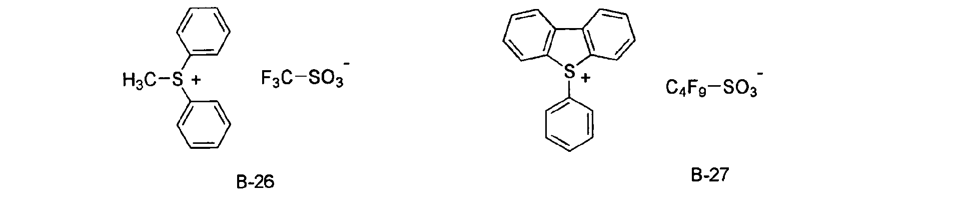

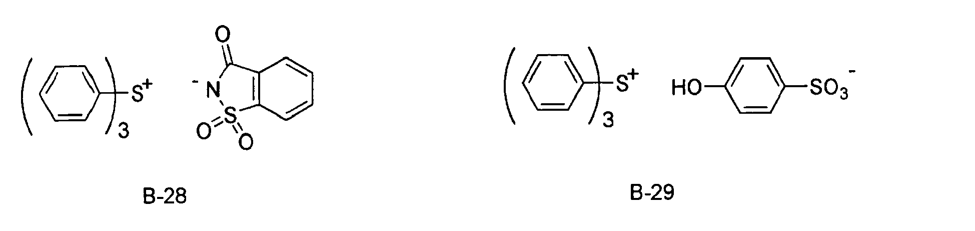

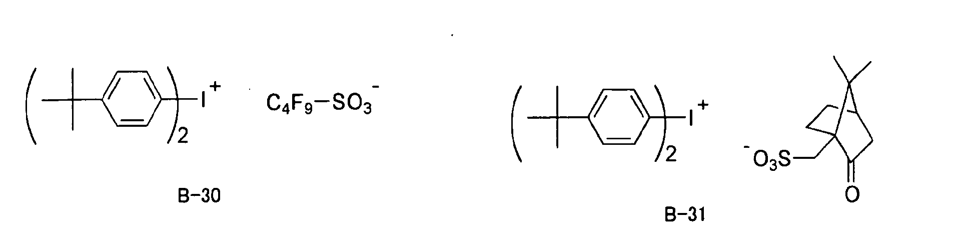

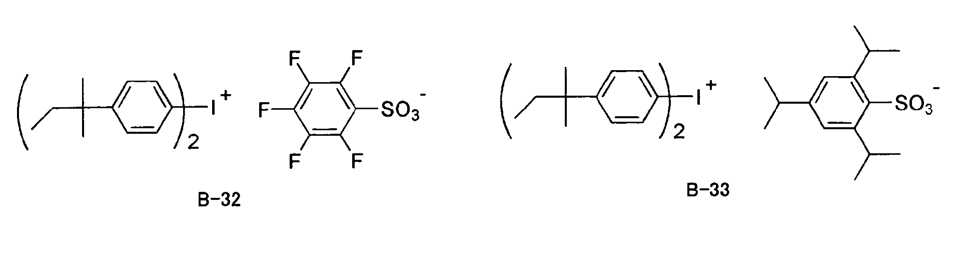

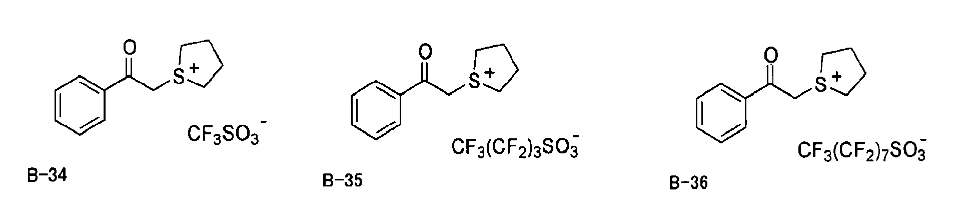

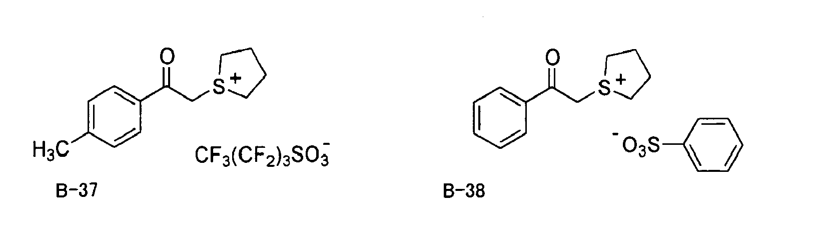

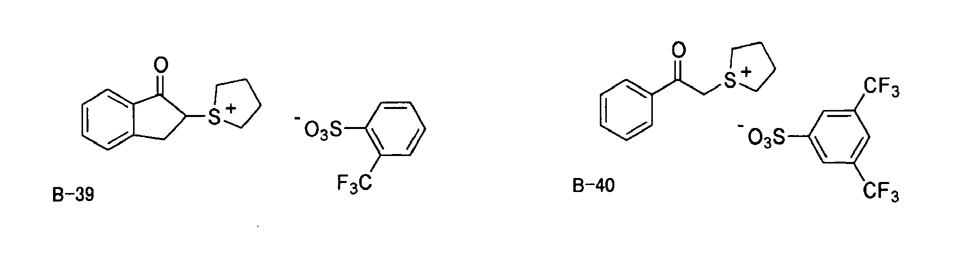

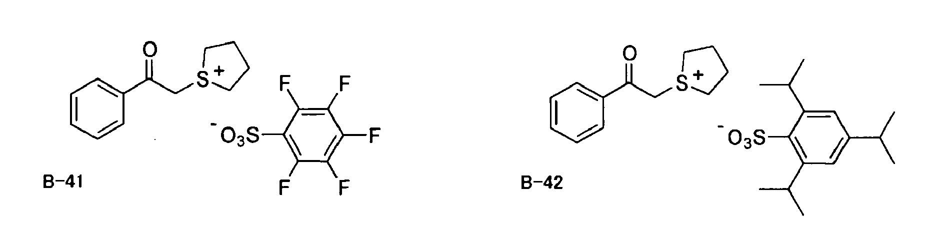

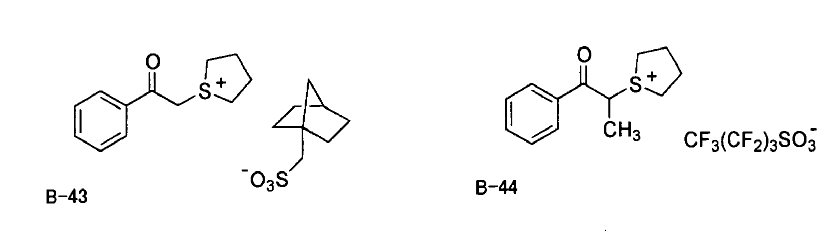

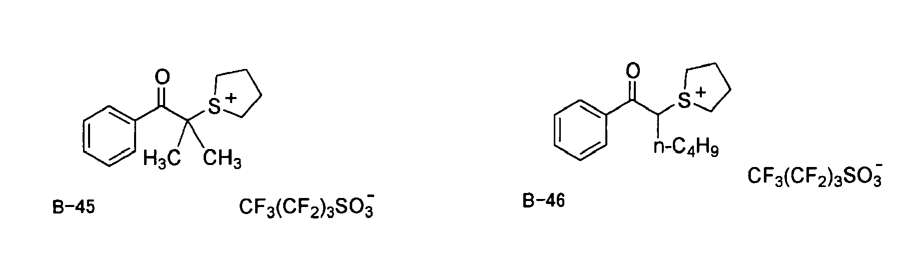

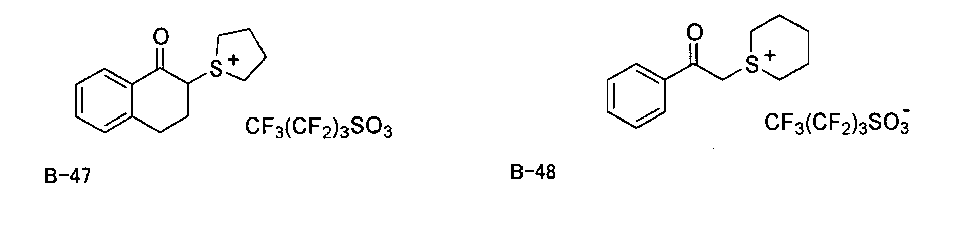

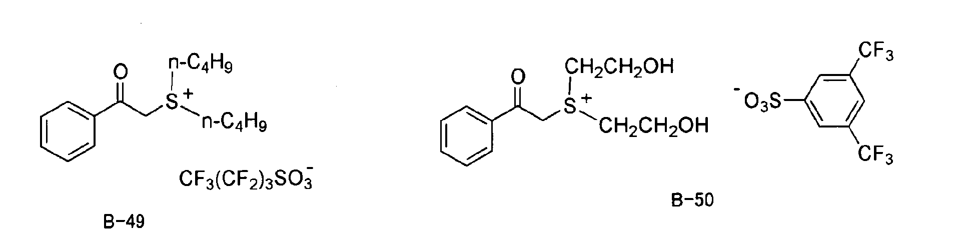

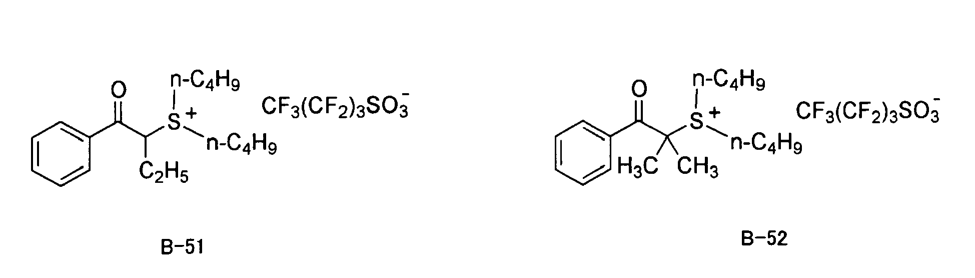

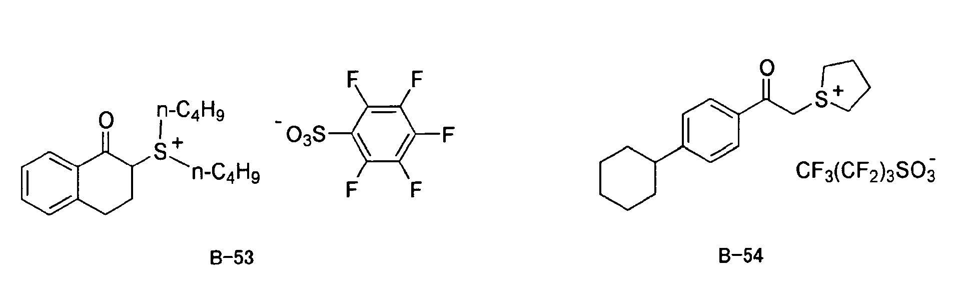

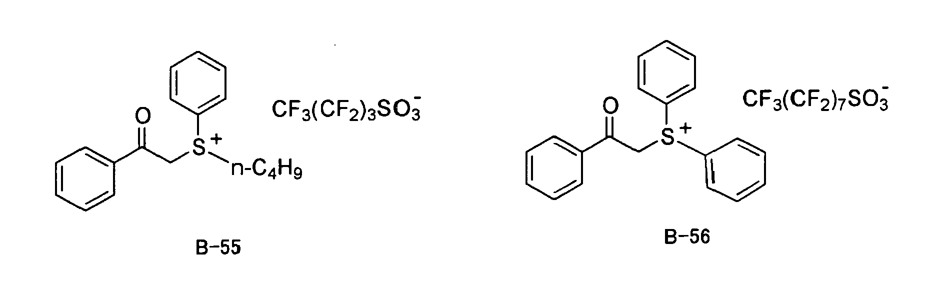

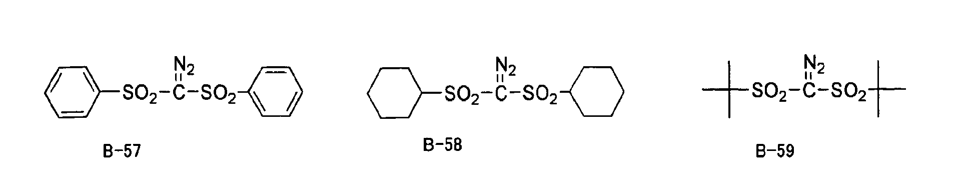

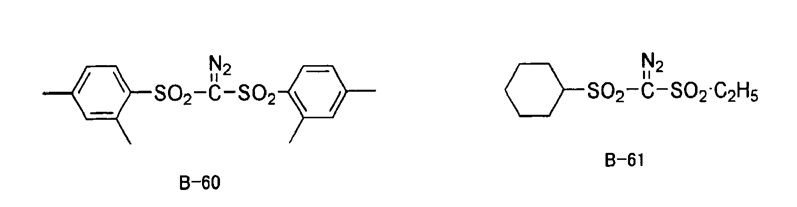

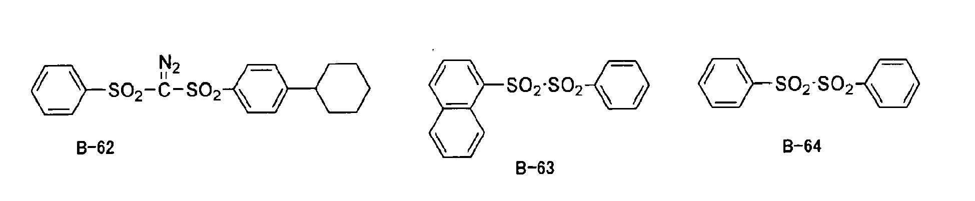

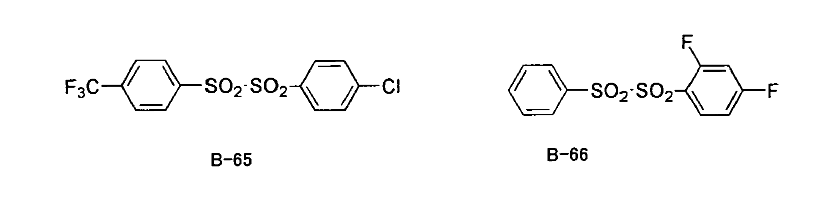

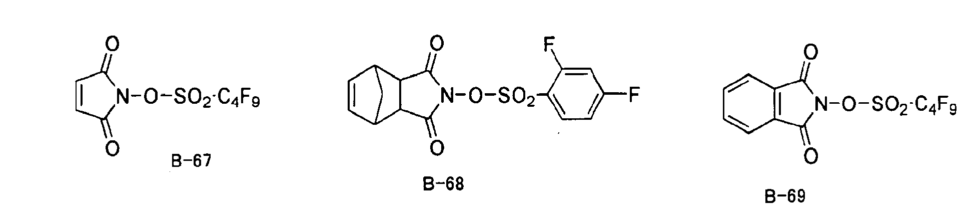

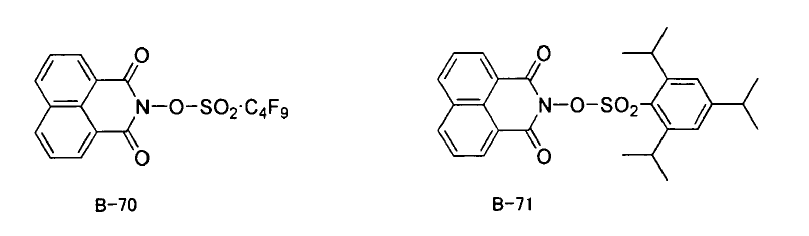

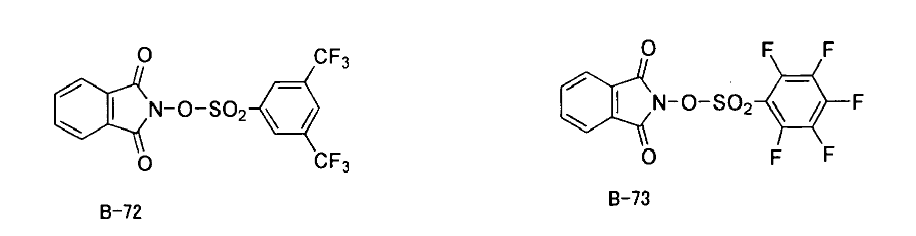

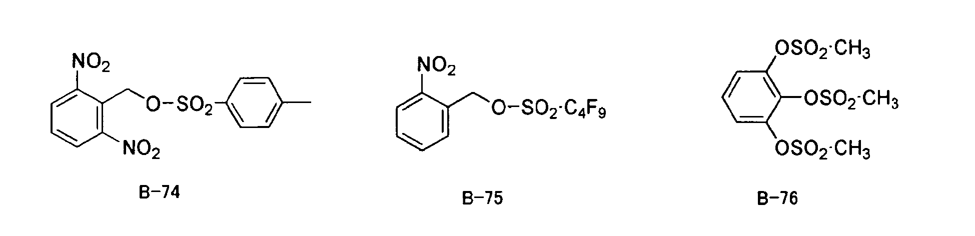

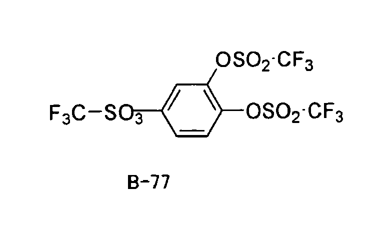

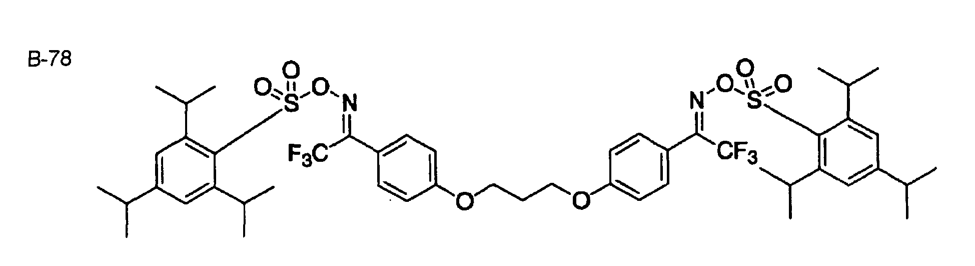

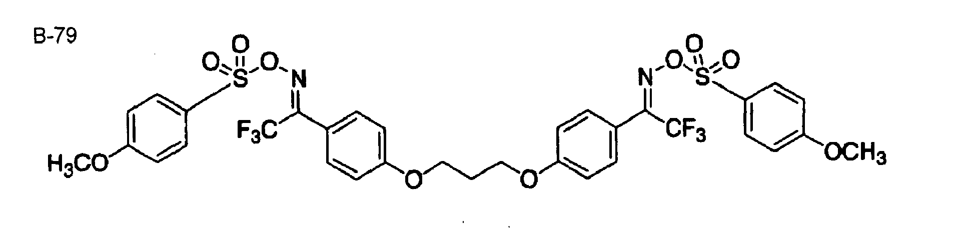

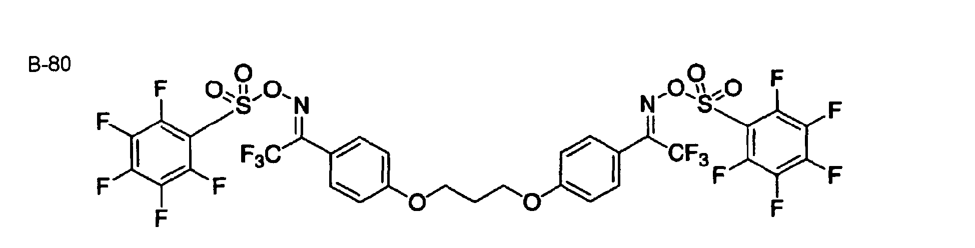

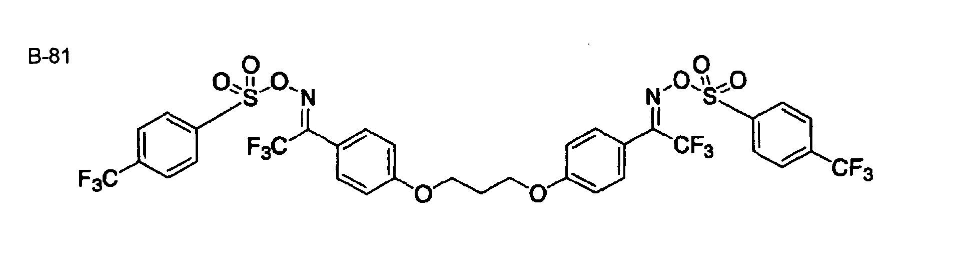

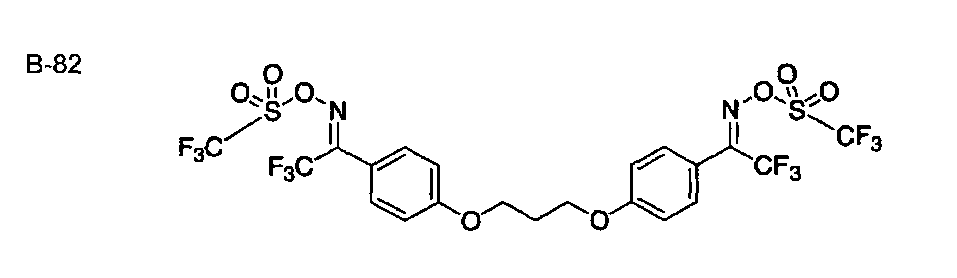

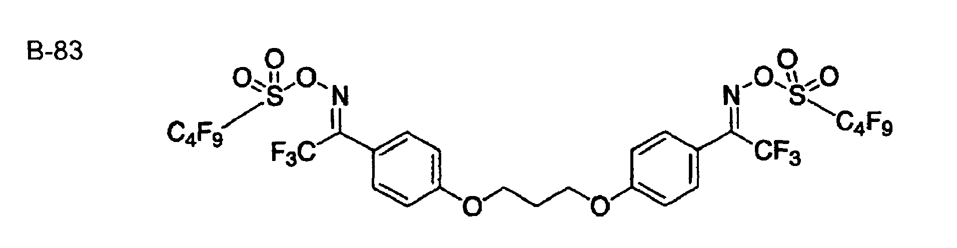

The content of the sulfonic acid generator is from 5 to 20 mass%, preferably from 6 to 18 mass%, more preferably from 7 to 16 mass%, based on the entire solid content of the resist composition. The content is 5 mass% or more in view of sensitivity or line edge roughness and 20 mass% or less in view of resolving power, pattern profile and film quality. One kind of the sulfonic acid generator may be used, or two or more kinds thereof may be mixed and used. For example, a compound capable of generating an arylsulfonic acid upon irradiation with actinic rays or radiation and a compound capable of generating an alkylsulfonic acid upon irradiation with actinic rays or radiation may be used in combination as the sulfonic acid generator.

The sulfonic acid generator can be synthesized by a known method such as synthesis method described in JP-A-2002-27806.

In the resist composition of the present invention, a compound capable of generating a carboxylic acid upon irradiation with actinic rays or radiation (hereinafter, sometimes referred to as a "carboxylic acid generator") may be used together with the sulfonic acid generator.

The carboxylic acid generator is preferably a compound represented by the following formula (C):

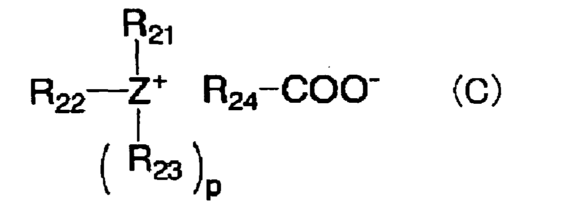

In formula (C), R₂₁ to R₂₃ each independently represents an alkyl group, a cycloalkyl group, an alkenyl group or an aryl group.

R₂₄ represents a hydrogen atom, an alkyl group, a cycloalkyl group, an alkenyl group or an aryl group.

Z represents a sulfur atom or an iodine atom. p is 1 when Z is a sulfur atom, and p is 0 when Z is an iodine atom.

In formula (C), R₂₁ to R₂₃ each independently represents an alkyl group, a cycloalkyl group, an alkenyl group or an aryl group, and these groups each may have a substituent.

Examples of the substituent which the alkyl group, cycloalkyl group and alkenyl group each may have include a halogen atom (e.g., chlorine, bromine, fluorine), an aryl group (e.g., phenyl, naphthyl), a hydroxy group and an alkoxy group (e.g., methoxy, ethoxy, butoxy).

Examples of the substituent which the aryl group may have include a halogen atom (e.g., chlorine, bromine, fluorine), a nitro group, a cyano group, an alkyl group (e.g., methyl, ethyl, tert-butyl, tert-amyl, octyl), a hydroxy group and an alkoxy group (e.g., methoxy, ethoxy, butoxy).

R₂₁ to R₂₃ each is, independently, preferably an alkyl group having a carbon number of 1 to 12, a cycloalkyl group having a carbon number of 3 to 12, an alkenyl group having a carbon number of 2 to 12 or an aryl group having a carbon number of 6 to 24, more preferably an alkyl group having a carbon number of 1 to 6, a cycloalkyl group having a carbon number of 3 to 6 or an aryl group having a carbon number of 6 to 18, still more preferably an aryl group having a carbon number of 6 to 15, and these groups each may have a substituent.

R₂₄ represents a hydrogen atom, an alkyl group, a cycloalkyl group, an alkenyl group or an aryl group.

Examples of the substituent which the alkyl group, cycloalkyl group and alkenyl group each may have are the same as those of the substituent described above when R₂₁ is an alkyl group. Examples of the substituent for the aryl group are the same as those of the substituent described above when R₂₁ is an aryl group.

R₂₄ is preferably a hydrogen atom, an alkyl group having a carbon number of 1 to 30, a cycloalkyl group having a carbon number of 3 to 30, an alkenyl group having a carbon number of 2 to 30 or an aryl group having a carbon number of 6 to 24, more preferably an alkyl group having a carbon number of 1 to 18, a cycloalkyl group having a carbon number of 3 to 18 or an aryl group having a carbon number of 6 to 18, still more preferably an alkyl group having a carbon number of 1 to 12, a cycloalkyl group having a carbon number of 3 to 12 or an aryl group having a carbon number of 6 to 15. These groups each may have a substituent.

Z represents a sulfur atom or an iodine atom. p is 1 when Z is a sulfur atom, and 0 when Z is an iodine atom.

Incidentally, two or more cation moieties of formula (C) may combine through a single bond or a linking group (e.g., - S-, -O-) to form a cation structure having a plurality of cation moieties of formula (C).

Specific preferred examples of the compound capable of generating a carboxylic acid upon irradiation with actinic rays or radiation are set forth below, but the present invention is of course not limited thereto.

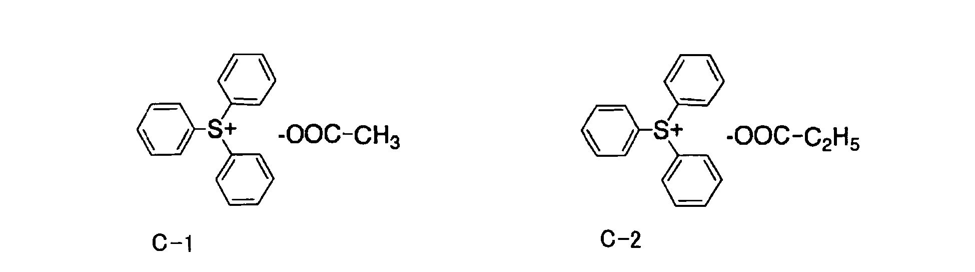

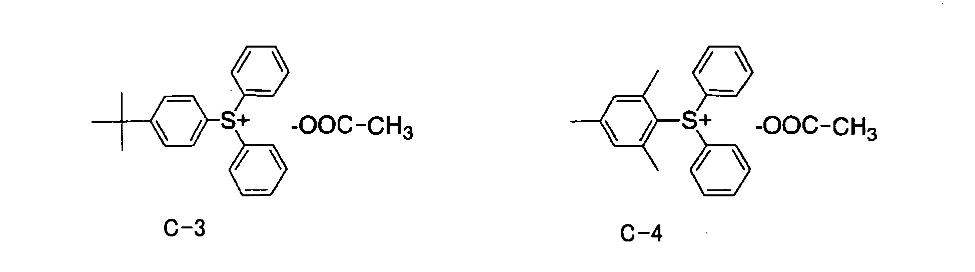

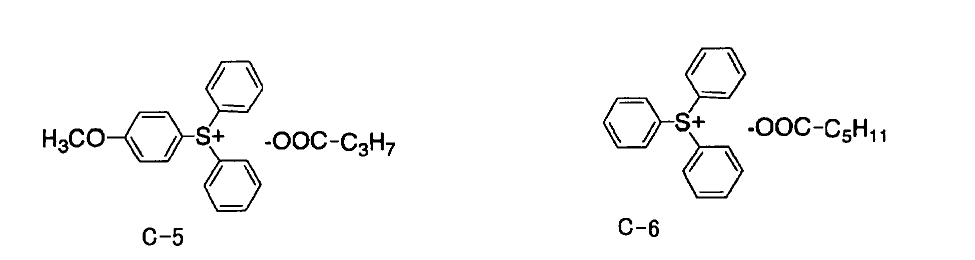

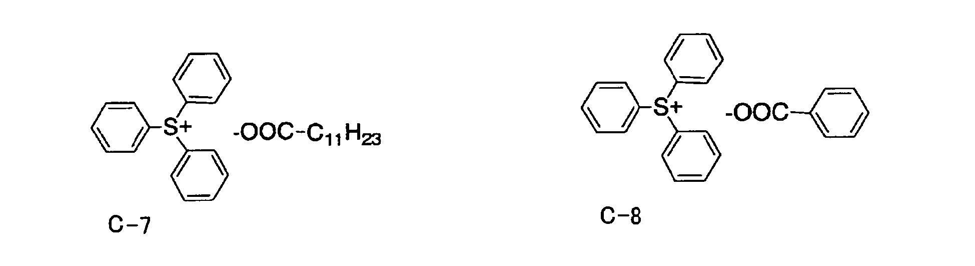

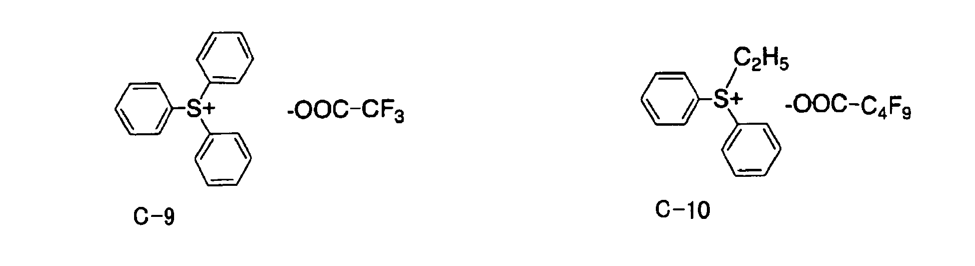

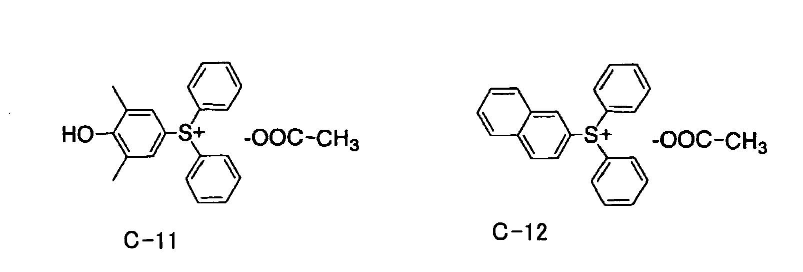

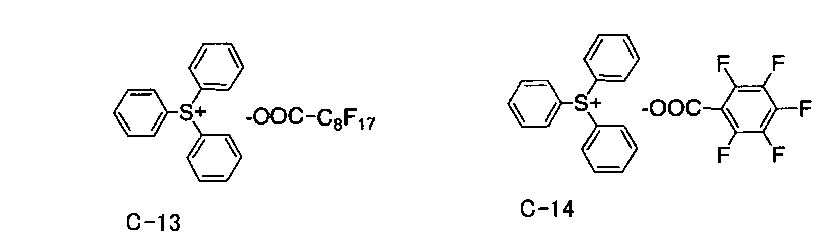

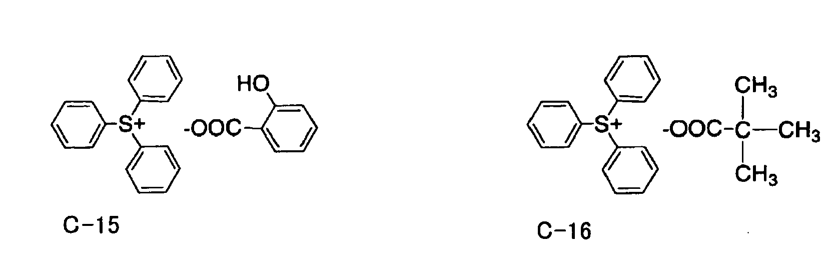

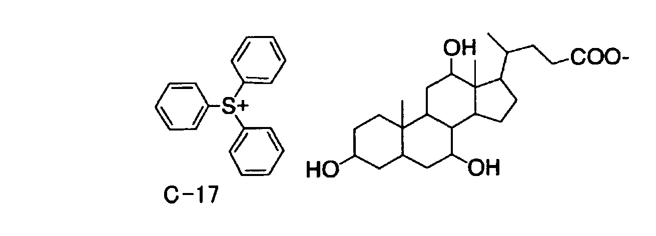

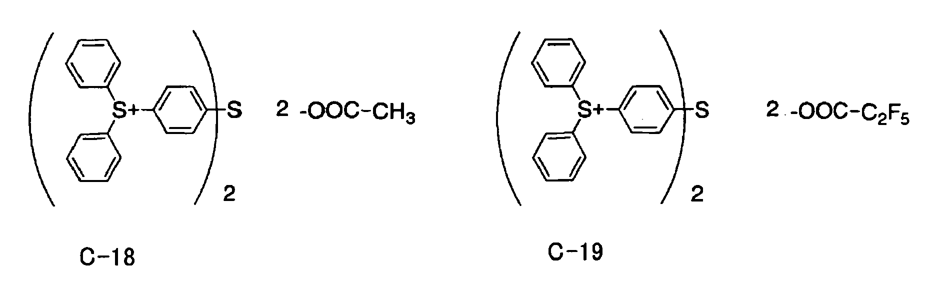

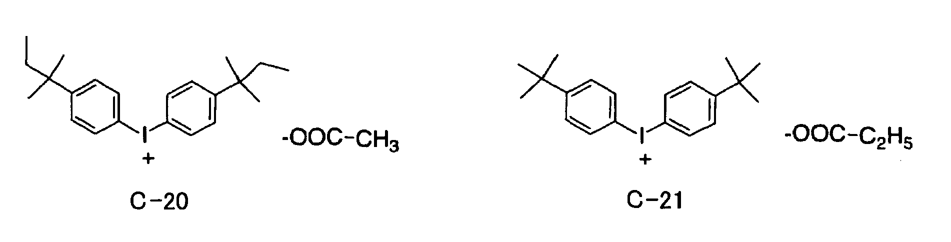

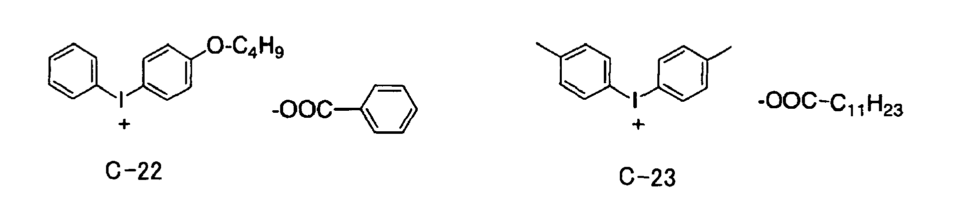

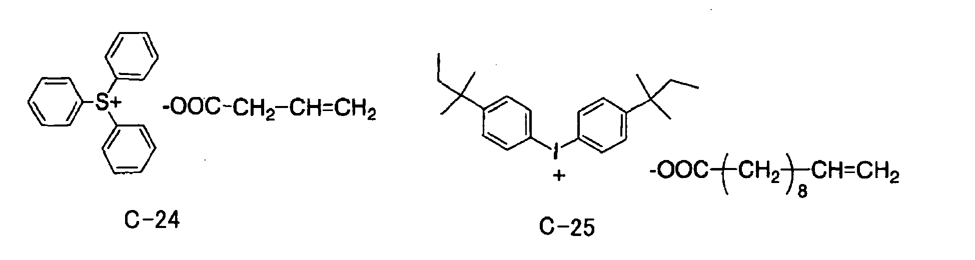

The content of the carboxylic acid generator in the resist composition of the present invention is preferably from 0.01 to 10 mass%, more preferably from 0.03 to 5 mass%, still more preferably from 0.05 to 3 mass%, based on the entire solid content of the composition. One of these compounds capable of generating a carboxylic acid upon irradiation with actinic rays or radiation may be used, or two or more kinds thereof may be mixed and used.

The carboxylic acid generator/sulfonic acid generator (ratio by mass) is usually from 99.9/0.1 to 50/50, preferably from 99/1 to 60/40, more preferably from 98/2 to 70/30.

The carboxylic acid generator can be synthesized by a known method such as synthesis method described in JP-A-2002-27806.

### Organic basic compound:

In the present invention, an organic basic compound is preferably used, for example, from the standpoint of enhancing the performance such as resolving power or the storage stability. The organic basic compound is more preferably a compound containing a nitrogen atom (nitrogen-containing basic compound).

The organic basic compound preferred in the present invention is a compound having basicity stronger than that of phenol.

The preferred chemical environment thereof includes structures of the following formulae (A) to (E). The structures of formulae (B) to (E) each may be a part of a ring structure.

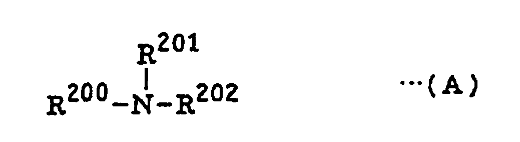

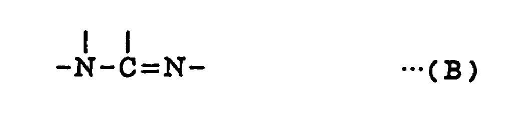

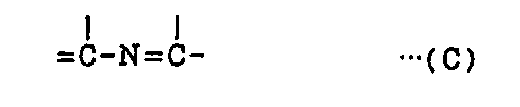

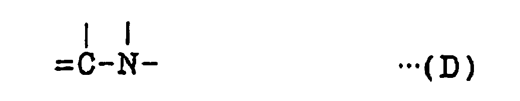

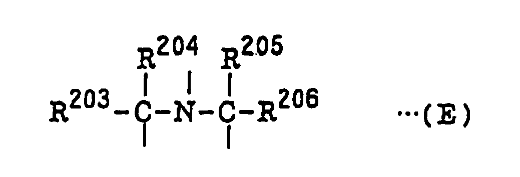

In formula (A), R²⁰⁰, R²⁰¹ and R²⁰², which may be the same or different, each represents a hydrogen atom, an alkyl group or cycloalkyl group having a carbon number of 1 to 20, or an aryl group having a carbon number of 6 to 20, and R²⁰¹ and R²⁰² may combine with each other to form a ring.

The alkyl group, cycloalkyl group and aryl group as R²⁰⁰, R²⁰¹ and R²⁰² each may have a substituent. The alkyl group or cycloalkyl group having a substituent is preferably an aminoalkyl group or aminocycloalkyl group having a carbon number of 1 to 20, or a hydroxyalkyl group having a carbon number of 1 to 20.

In formula (E), R²⁰³, R²⁰⁴, R²⁰⁵ and R²⁰⁶, which may be the same or different, each represents an alkyl group or cycloalkyl group having a carbon number of 1 to 6.

The compound is more preferably a nitrogen-containing basic compound having two or more nitrogen atoms differing in the chemical environment within one molecule, still more preferably a compound containing both a substituted or unsubstituted amino group and a nitrogen-containing ring structure, or a compound having an alkylamino group.

Specific preferred examples thereof include guanidine, aminopyridine, aminoalkylpyridine, aminopyrrolidine, indazole, imidazole, pyrazole, pyrazine, pyrimidine, purine, imidazoline, pyrazoline, piperazine, aminomorpholine and aminoalkylmorpholine. Preferred examples of the substituent which these compounds each may have include an amino group, an alkylamino group, an aminoaryl group, an arylamino group, an alkyl group (as the substituted alkyl group, particularly an aminoalkyl group), an alkoxy group, an acyl group, an acyloxy group, an aryl group, an aryloxy group, a nitro group, a hydroxyl group and a cyano group.

More preferred examples of the compound include, but are not limited to, guanidine, 1,1-dimethylguanidine, 1,1,3,3-tetramethylguanidine, imidazole, 2-methylimidazole, 4-methylimidazole, N-methylimidazole, 2-phenylimidazole, 4,5-diphenylimidazole, 2,4,5-triphenylimidazole, 2-aminopyridine, 3-aminopyridine, 4-aminopyridine, 2-dimethylaminopyridine, 4-dimethylaminopyridine, 2-diethylaminopyridine, 2-(aminomethyl)pyridine, 2-amino-3-methylpyridine, 2-amino-4-methylpyridine, 2-amino-5-methylpyridine, 2-amino-6-methylpyridine, 3-aminoethylpyridine, 4-aminoethylpyridine, 3-aminopyrrolidine, piperazine, N-(2-aminoethyl)piperazine, N-(2-aminoethyl)piperidine, 4-amino-2,2,6,6-tetramethylpiperidine, 4-piperidinopiperidine, 2-iminopiperidine, 1-(2-aminoethyl)pyrrolidine, pyrazole, 3-amino-5-methylpyrazole, 5-amino-3-methyl-1-p-tolylpyrazole, pyrazine, 2-(aminomethyl)-5-methylpyrazine, pyrimidine, 2,4-diaminopyrimidine, 4,6-dihydroxypyrimidine, 2-pyrazoline, 3-pyrazoline, N-aminomorpholine and N-(2-aminoethyl)morpholine.

One of these nitrogen-containing basic compounds may be used alone, or two or more kinds thereof may be used in combination.

A tetraalkylammonium salt-type nitrogen-containing basic compound may also be used. Among such compounds, a tetraalkylammonium hydroxide having a carbon number of 1 to 8 (e.g., tetramethylammonium hydroxide, tetraethylammonium hydroxide, tetra-(n-butyl)ammonium hydroxide) is preferred.

One of these nitrogen-containing basic compounds may be used alone, or two or more kinds thereof may be used in combination.

As for the ratio between the acid generator and the organic basic compound used in the composition, the (total amount of acid generator)/(organic basic compound) (ratio by mol) is preferably from 2.5 to 300. When this molar ratio is 2.5 or more, high sensitivity is obtained, and when the molar ratio is 300 or less, the resist pattern can be prevented from thickening in aging after exposure until heat treatment and the resolving power can be enhanced. The (total amount of acid generator)/(organic basic compound) (ratio by mol) is more preferably from 5.0 to 200, still more preferably from 7.0 to 150.

### Surfactants:

In the present invention, surfactants may be used and this is preferred in view of film-forming property, adhesion of pattern, reduction of development defects, and the like.

Specific examples of the surfactant include a nonionic surfactant such as polyoxyethylene alkyl ethers (e.g., polyoxyethylene lauryl ether, polyoxyethylene stearyl ether, polyoxyethylene cetyl ether, polyoxyethylene oleyl ether), polyoxyethylene alkylallyl ethers (e.g., polyoxyethylene octylphenol ether, polyoxyethylene nonylphenol ether), polyoxyethylene•polyoxypropylene block copolymers, sorbitan fatty acid esters (e.g., sorbitan monolaurate, sorbitan monopalmitate, sorbitan monostearate, sorbitan monooleate, sorbitan trioleate, sorbitan tristearate) and polyoxyethylene sorbitan fatty acid esters (e.g., polyoxyethylene sorbitan monolaurate, polyoxyethylene sorbitan monopalmitate, polyoxyethylene sorbitan monostearate, polyoxyethylene sorbitan trioleate, polyoxyethylene sorbitan tristearate); a fluorine-containing surfactant and a silicon-containing surfactant, such as EFtop EF301, EF303 and EF352 (produced by Shin-Akita Chemical Co., Ltd.), Megafac F171 and F173 (produced by Dainippon Ink & Chemicals, Inc.), Florad FC430 and FC431 (produced by Sumitomo 3M Inc.), Asahiguard AG710, Surflon S-382, SC101, SC102, SC103, SC104, SC105 and SC106 (produced by Asahi Glass Co., Ltd.), and Troysol S-366 (produced by Troy Chemical Industries, Inc.); an organosiloxane polymer, KP-341 (produced by Shin-Etsu Chemical Co., Ltd.); and acrylic acid-based or methacrylic acid-based (co)polymers Polyflow No. 75 and No. 95 (produced by Kyoeisha Yushi Kagaku Kogyo Co., Ltd.).

The amount of such a surfactant blended is usually 2 parts by mass or less, preferably 1 part by mass or less, per 100 parts by mass of the solid content in the composition of the present invention.

One of these surfactants may be used alone or several species thereof may be added in combination.

As for the surfactant, the composition preferably contains any one species of fluorine- and/or silicon-containing surfactants (a fluorine-containing surfactant, a silicon-containing surfactant or a surfactant containing both a fluorine atom and a silicon atom), or two or more species thereof.

Examples of these surfactants include the surfactants described in JP-A-62-36663, JP-A-61-226746, JP-A-61-226745, JP-A-62-170950, JP-A-63-34540, JP-A-7-230165, JP-A-8-62834, JP-A-9-54432, JP-A-9-5988, JP-A-2002-277862 and U.S. Patents 5,405,720, 5,360,692, 5,529,881, 5,296,330, 5,436,098, 5,576,143, 5,294,511 and 5,824,451. The following commercially available surfactants each may also be used as it is.

Examples of the commercially available surfactant which can be used include a fluorine-containing or silicon-containing surfactant such as EFtop EF301 and EF303 (produced by Shin-Akita Chemical Co., Ltd.), Florad FC430 and 431 (produced by Sumitomo 3M Inc.), Megafac F171, F173, F176, F189 and R08 (produced by Dainippon Ink & Chemicals, Inc.), Surflon S-382, SC101, 102, 103, 104, 105 and 106 (produced by Asahi Glass Co., Ltd.), and Troysol S-366 (produced by Troy Chemical Industries, Inc.). In addition, a polysiloxane polymer KP-341 (produced by Shin-Etsu Chemical Co., Ltd.) may also be used as the silicon-containing surfactant.

Other than these known surfactants, a surfactant using a polymer having a fluoroaliphatic group derived from a fluoroaliphatic compound produced by a telomerization process (also called a telomer process) or an oligomerization process (also called an oligomer process) may be used. The fluoroaliphatic compound can be synthesized by the method described in JP-A-2002-90991.

The polymer having a fluoroaliphatic group is preferably a copolymer of a fluoroaliphatic group-containing monomer with a (poly(oxyalkylene)) acrylate and/or a (poly(oxyalkylene)) methacrylate, and the polymer may have an irregular distribution or may be a block copolymer. Examples of the poly(oxyalkylene) group include a poly(oxyethylene) group, a poly(oxypropylene) group and a poly(oxybutylene) group. This group may also be a unit having alkylenes differing in the chain length within the same chain, such as block-linked poly(oxyethylene, oxypropylene and oxyethylene) and block-linked poly(oxyethylene and oxypropylene). Furthermore, the copolymer of a fluoroaliphatic group-containing monomer with a (poly(oxyalkylene)) acrylate (or methacrylate) may be not only a binary copolymer but also a ternary or higher copolymer obtained by simultaneously copolymerizing two or more different fluoroaliphatic group-containing monomers or two or more different (poly(oxyalkylene)) acrylates (or methacrylates).

Examples thereof include commercially available surfactants such as Megafac F178, F-470, F-473, F-475, F-476 and F-472 (produced by Dainippon Ink & Chemicals, Inc.), and further include a copolymer of a C₆F₁₃ group-containing acrylate (or methacrylate) with a (poly(oxyalkylene)) acrylate (or methacrylate), a copolymer of a C₆F₁₃ group-containing acrylate (or methacrylate) with (poly(oxyethylene)) acrylate (or methacrylate) and (poly(oxypropylene)) acrylate (or methacrylate), a copolymer of a C₈F₁₇ group-containing acrylate (or methacrylate) with a (poly(oxyalkylene)) acrylate (or methacrylate), and a copolymer of a C₈F₁₇ group-containing acrylate (or methacrylate) with (poly(oxyethylene)) acrylate (or methacrylate) and (poly(oxypropylene)) acrylate (or methacrylate).

The amount of the surfactant used is preferably from 0.0001 to 2 mass%, more preferably from 0.001 to 1 mass%, based on the entire amount of the resist composition (excluding the solvent).

### Other components:

The resist composition of the present invention may further contain, if desired, a dye, a photobase generator and the like.

### 1. Dye

In the present invention, a dye may be used.

The suitable dye includes an oily dye and a basic dye. Specific examples thereof include Oil Yellow #101, Oil Yellow #103, Oil Pink #312, Oil Green BG, Oil Blue BOS, Oil Blue #603, Oil Black BY, Oil Black BS, Oil Black T-505 (all produced by Orient Chemical Industries Co., Ltd.), Crystal Violet (CI42555), Methyl Violet (CI42535), Rhodamine B (CI45170B), Malachite Green (CI42000) and Methylene Blue (CI52015).

### 2. Photobase generator

Examples of the photobase generator which can be added to the composition of the present invention include compounds described in JP-A-4-151156, JP-A-4-162040, JP-A-5-197148, JP-A-5-5995, JP-A-6-194834, JP-A-8-146608, JP-A-10-83079 and European Patent 622,682. Specific examples of the photobase generator which can be suitably used include 2-nitrobenzyl carbamate, 2,5-dinitrobenzylcyclohexyl carbamate, N-cyclohexyl-4-methylphenylsulfonamide and 1,1-dimethyl-2-phenylethyl-N-isopropyl carbamate. Such a photobase generator is added for the purpose of improving the resist profile or the like.

### 3. Solvents

The resist composition of the present invention after dissolving the components described above in a solvent is coated on a support. Usually, the concentration is, in terms of the solid content concentration of all resist components, preferably from 2 to 30 mass%, more preferably from 3 to 25 mass%.

Preferred examples of the solvent used here include ethylene dichloride, cyclohexanone, cyclopentanone, 2-heptanone, γ-butyrolactone, methyl ethyl ketone, ethylene glycol monomethyl ether, ethylene glycol monoethyl ether, 2-methoxyethyl acetate, ethylene glycol monoethyl ether acetate, propylene glycol monomethyl ether, propylene glycol monomethyl ether acetate, toluene, ethyl acetate, methyl lactate, ethyl lactate, methyl methoxypropionate, ethyl ethoxypropionate, methyl pyruvate, ethyl pyruvate, propyl pyruvate, N,N-dimethylformamide, dimethylsulfoxide, N-methylpyrrolidone and tetrahydrofuran. One of these solvents is used alone, or several species thereof are mixed and used.

The resist composition of the present invention is coated on a substrate to form a thin film. The thickness of this coated film is preferably from 0.05 to 4.0 µm.

In the present invention, a commercially available inorganic or organic antireflection film may be used, if desired. Furthermore, the antireflection film may be used by coating it as an underlayer of the resist.

The antireflection film used as the underlayer of the resist may be either an inorganic film type such as titanium, titanium dioxide, titanium nitride, chromium oxide, carbon and amorphous silicon, or an organic film type comprising a light absorbent and a polymer material. The former requires equipment for the film formation, such as vacuum deposition apparatus, CVD apparatus and sputtering apparatus. Examples of the organic antireflection film include a film comprising a diphenylamine derivative/formaldehyde-modified melamine resin condensate, an alkali-soluble resin and a light absorbent described in JP-B-7-69611 (the term "JP-B" as used herein means an "examined Japanese patent publication"), a reaction product of a maleic anhydride copolymer and a diamine-type light absorbent described in U.S. Patent 5,294,680, a film containing a resin binder and a methylolmelamine-based heat crosslinking agent described in JP-A-6-118631, an acrylic resin-type antireflection film containing a carboxylic acid group, an epoxy group and a light absorbing group within the same molecule described in JP-A-6-118656, a film comprising a methylolmelamine and a benzophenone-based light absorbent described in JP-A-8-87115, and a film obtained by adding a low molecular light absorbent to a polyvinyl alcohol resin described in JP-A-8-179509.

Also, the organic antireflection film may be a commercially available organic antireflection film such as DUV-30 Series and DUV-40 Series produced by Brewer Science, Inc.; and AR-2, AR-3 and AR-5 produced by Shipley Co., Ltd.

In the production or the like of a precision integrated circuit device, the step of forming a pattern on a resist film is performed by coating the positive resist composition of the present invention on a substrate (for example, a silicon/silicon dioxide-coated substrate, a glass substrate, an ITO substrate or a quartz/chromium oxide-coated substrate) to form a resist film, irradiating thereon actinic rays or radiation such as KrF excimer laser light, electron beam or EUV light, and then subjecting the resist film to heating, development, rinsing and drying, whereby a good resist pattern can be formed.

The alkali developer which can be used in the development is an aqueous solution of alkalis (usually, 0.1 to 20 mass%) such as inorganic alkalis (e.g., sodium hydroxide, potassium hydroxide, sodium carbonate, sodium silicate, sodium metasilicate, aqueous ammonia), primary amines (e.g., ethylamine, n-propylamine), secondary amines (e.g., diethylamine, di-n-butylamine), tertiary amines (e.g., triethylamine, methyldiethylamine), alcohol amines (e.g., dimetylethanolamine, triethanolamine), quaternary ammonium salts (e.g., tetramethylammonium hydroxide, tetraethylammonium hydroxide, choline), and cyclic amines (e.g., pyrrole, piperidine). This aqueous solution of alkalis may be used after adding thereto alcohols such as isopropyl alcohol or a surfactant such as nonionic surfactant in an appropriate amount.

Among these developers, a quaternary ammonium salt is preferred, and tetramethylammonium hydroxide and choline are more preferred.

The pH of the alkali developer is usually from 10 to 15.

### [Examples]

The present invention is described in greater detail below by referring to Examples, but the present invention should not be construed as being limited thereto. Synthesis Example 1: synthesis of 1-phenylethoxycarbonylmethylstyrene

A 500 ml-volume three-neck flask was nitrogen-purged, and 0.2 mol of magnesium powder was added thereto and thoroughly dried. Furthermore, 200 ml of dry THF was added and the system was cooled to -40°C. Subsequently, 0.1 mol of chloromethylstyrene was added dropwise thereto over 6 hours. After the completion of dropwise addition, the reaction was terminated by adding dry ice, and diisopropyl ether and an aqueous 5% sodium hydroxide solution were added to the reaction solution. Thereafter, the aqueous layer was washed with diisopropyl ether twice, an aqueous 5% hydrochloric acid solution was added dropwise to render the solution acidic, and carboxymethylstyrene was collected by filtration as a crystalline solid (yield: 70%). Next, 0.07 mol of the obtained carboxymethylstyrene and 0.1 mol of 1-phenethyl alcohol were dissolved in 200 ml of methylene chloride and after cooling to 0°C, 0.1 mol of DCC was added, followed by stirring for 1 hour. The reaction solution was filtered, and the filtrate was washed with an aqueous sodium chloride solution twice. The resulting solution was concentrated under reduced pressure and subjected to column chromatography (hexane/ethyl acetate = 10/1), whereby 1-phenylethoxycarbonylmethylstyrene was obtained as a transparent liquid (yield: 82%).

1HNMR: δ 1.68 (d, J=6.8 Hz, 3H), 3.51 (s, 2H), 5.18 (d, J=10.2 Hz, 1H), 5.42 (q, J=6.8 Hz, 1H), 5.61 (d, J=16.1 Hz, 1H), 6.63 (dd, J=10.2 Hz, 16.0 Hz, 1H), 7.18 (d, J=6.2 Hz, 2H), 7.20 (d, J=6.2 Hz, 2H).

Various monomers corresponding to the repeating unit represented by formula (I) could be synthesized in the same manner by varying the alcohol used.

### Synthesis Example 2: synthesis of Resin (A-1)

Acetoxystyrene and 1-phenylethoxycarbonylmethylstyrene were charged at a ratio of 80/20 (mole fraction) and dissolved in 1-methoxy-2-propanol to prepare 100 mL of a solution having a solid content concentration of 20 mass%. Subsequently, 2.5 mol% of a polymerization initiator, V-601, produced by Wako Pure Chemical Industries, Ltd. was added to the solution obtained, and the resulting solution was added dropwise to 10 ml of 1-methoxy-2-propanol heated at 80°C, over 6 hours in a nitrogen atmosphere. After the completion of dropwise addition, the reaction solution was heated for 2 hours. Furthermore, after the completion of reaction, the reaction solution was cooled to room temperature and then crystallized from 3 L of methanol/water (9/1), and the precipitated white powder was collected by filtration.

The compositional ratio of the polymer determined from C¹³NMR was 81/19 (by mol). Also, the weight average molecular weight determined by GPC was 12,500 in terms of standard polystyrene.

This polymer was dissolved in 100 ml of PGMEA/ethyl acetate (1/1), 5 ml of a 28% sodium methoxidemethanol solution was then added thereto and after stirring 1 hour, an aqueous 5% hydrochloric acid solution was added to precipitate the organic layer. The organic layer was washed with distilled water three times. The obtained polymer was concentrated under reduced pressure to obtain a 30% PGMEA solution. The weight average molecular weight of this polymer solution determined by GPC was 11,000 in terms of standard polystyrene.

### Synthesis Example 3: synthesis of Resin (A-13)

Acetoxystyrene, 1-[(4'-methoxy)phenyl]ethoxycarbonyl-methylstyrene and 1-ethoxyethoxystyrene were charged at a ratio of 65/25/10 (mole fraction) and dissolved in 1-methoxy-2-propanol to prepare 100 mL of a solution having a solid content concentration of 20 mass%. Subsequently, 2.5 mol% of a polymerization initiator, V-601, produced by Wako Pure Chemical Industries, Ltd. was added to the solution obtained, and the resulting solution was added dropwise to 10 ml of 1-methoxy-2-propanol heated at 80°C, over 6 hours in a nitrogen atmosphere. After the completion of dropwise addition, the reaction solution was heated for 2 hours. Furthermore, after the completion of reaction, the reaction solution was cooled to room temperature and then crystallized from 3 L of methanol/water (9/1), and the precipitated white powder was collected by filtration.

The compositional ratio of the polymer determined from C¹³NMR was 64/26/10 (by mol). Also, the weight average molecular weight determined by GPC was 13,700 in terms of standard polystyrene.

This polymer was dissolved in 100 ml of PGMEA/ethyl acetate (1/1), 5 ml of a 28% sodium methoxidemethanol solution was then added thereto and after stirring for 1 hour, an aqueous 5% ammonium chloride solution was added to extract the organic layer. The organic layer was washed with distilled water three times. The obtained polymer was concentrated under reduced pressure to obtain a 30% PGMEA solution. The weight average molecular weight of this polymer solution determined by GPC was 12,300 in terms of standard polystyrene.

Other resins (A) and acid generators all were synthesized by known synthesis methods such as synthesis method described in JP-A-2002-27806.

The repeating units (mol%, corresponding to repeating units from the left), weight average molecular weight and dispersity of each of Resins (A-1) to (A-25) are shown in Table 1 below.

**Table 1**

| Resin | Repeating Unit (mol%) | Weight Average Molecular Weight | Dispersity |
|---|---|---|---|
| A-1 | 81/19 | 11000 | 1.58 |
| A-2 | 75/25 | 10500 | 1.65 |
| A-3 | 77/23 | 14000 | 1.59 |
| A-4 | 82/18 | 13800 | 1.75 |
| A-5 | 85/15 | 10000 | 1.75 |
| A-6 | 83/17 | 13100 | 1.82 |
| A-7 | 73/27 | 15200 | 1.65 |
| A-8 | 78/22 | 14600 | 1.52 |
| A-9 | 75/25 | 12300 | 1.59 |
| A-10 | 72/28 | 12700 | 1.75 |
| A-11 | 65/20/15 | 13400 | 1.79 |
| A-12 | 66/18/16 | 15200 | 1.63 |
| A-13 | 64/26/10 | 12300 | 1.52 |
| A-14 | 70/10/20 | 13200 | 1.84 |
| A-15 | 73/11/16 | 15300 | 1.74 |
| A-16 | 65/14/21 | 14700 | 1.69 |
| A-17 | 72/13/15 | 12400 | 1.58 |
| A-18 | 63/21/16 | 10800 | 1.71 |
| A-19 | 68/17/15 | 12500 | 1.83 |
| A-20 | 63/22/15 | 11000 | 1.79 |
| A-21 | 60/15/25 | 16700 | 1.56 |
| A-22 | 65/10/25 | 15600 | 1.65 |
| A-23 | 64/13/23 | 16900 | 1.69 |
| A-24 | 59/16/25 | 15400 | 1.71 |
| A-25 | 61/18/21 | 14600 | 1.68 |

### Example 1:

| Preparation and Coating of Positive Resist: | |
|---|---|
| Resin (A-1) | 0.93 g |
| Sulfonic Acid Generator (B-2) | 0.07 g |

These components were dissolved in 8.8 g of propylene glycol monomethyl ether acetate, and 0.003 g of D-1 (see below) as the organic basic compound and 0.001 g of Megafac F176 (produced by Dainippon Ink & Chemicals, Inc., hereinafter simply referred to as "W-1") as the surfactant were further added thereto and dissolved. The obtained solution was microfiltered through a membrane filter having a pore size of 0.1 µm to obtain a resist solution.

This resist solution was coated on a 6-inch silicon wafer having coated thereon an organic antireflection film ((DUV-30) produced by Brewer Science), by using a spin coater, Mark 8, manufactured by Tokyo Electron Ltd. and then baked at 110°C for 90 seconds to obtain a uniform film having a thickness of 0.25 µm.

### Formation and Evaluation of Positive Resist Pattern:

The resist film formed above was then irradiated with electron beams by using an electron beam image-drawing apparatus (HL750, manufactured by Hitachi Ltd., accelerating voltage: 50 KeV). After the irradiation, the resist film was baked at 110°C for 90 seconds, dipped in an aqueous 2.38 mass% tetramethylammonium hydroxide (TMAH) solution for 60 seconds, rinsed with water for 30 seconds and then dried. The obtained pattern was evaluated by the following methods.

### Sensitivity:

The cross-sectional profile of the pattern obtained was observed using a scanning electron microscope (S-4300, manufactured by Hitachi, Ltd.). The minimum irradiation energy for resolving a 0.15-µm line (line:space = 1:1) was taken as the sensitivity.

### LWR (Line Width Roughness):

With respect to a resist pattern obtained in the same manner as above, the line width was observed by a scanning electron microscope (S-9220, manufactured by Hitachi, Ltd.) to inspect the line width fluctuation (LWR) in the line width of 130 nm. The line width was detected at a plurality of positions in the measuring monitor by using a length-measuring scanning electron microscope (SEM), and the amplitude dispersion (3σ) at the detection positions was used as an index for LWR.

### Defocus Latitude Depended on Line Pitch:

In a 0.15-µm line pattern at the irradiation dose giving the above-described sensitivity, the line width of a dense pattern (line:space = 1:1) and the line width of an isolated pattern were measured. The difference therebetween was taken as the defocus latitude depended on line pitch.

The results of Example 1 were good, that is, the sensitivity was 10.0 µC/cm², LWR was 6.8 nm, and the defocus latitude depended on line pitch was 11 nm. The evaluation results are shown in Table 2.

### Examples 2 to 7 and Comparative Examples 1 and 2:

Using the compounds shown in Table 2, the preparation and coating of resist and the evaluation by electron beam exposure were performed thoroughly in the same manner as in Example 1. The evaluation results are shown in Table 2.

**Table 2**

| | Resin | Acid Generator | Basic Compound (0.003 g) | Surfactant (0.001 g) | Sensitivity (µC/cm²) | LWR (nm) | Defocus Latitude Depended on Line |
|---|---|---|---|---|---|---|---|
| Example 1 | A-1 (0.93 g) | B-2 (0.07 g) | D-1 | W-1 | 10.0 | 6.8 | 11 |
| Example 2 | A-2 (0.35 g) | B-4 (0.07 g) | D-2 | W-1 | 10.0 | 7.2 | 12 |
| Example 3 | A-3 (0.35 g) | B-16 (0.07 g) | D-3 | W-2 | 11.0 | 6.9 | 11 |
| Example 4 | A-4 (0.25 g) | B-17 (0.07 g) | D-1 | W-2 | 11.0 | 7.3 | 12 |
| Example 5 | A-11 (0.35 g) | B-1 (0.07 g) | D-3 | W-1 | 12.0 | 8.1 | 10 |
| Example 6 | A-12 (0.35 g) | B-3 (0.07 g) | D-3 | w-1 | 11.0 | 6.5 | 10 |
| Example 7 | A-13 (0.35 g) | B-5 (0.07 g) | D-2 | W-1 | 10.0 | 8.0 | 11 |
| Comparative Example 1 | C-1* (0.93 g) | B-2 (0.07 g) | D-1 | W-1 | 13.0 | 10.1 | 29 |
| Comparative Example 2 | C-2* (0.93 g) | B-2 (0.07 g) | D-1 | W-1 | 14.2 | 12.2 | 24 |

Abbreviations in Table 2 are as follows.
Organic Basic Compound:
   D-1: tri-n-hexylamine
   D-2: 2,4,6-triphenylimidazole
   D-3: tetra-(n-butyl)ammonium hydroxide
   Surfactant:
      W-1: fluorine-containing surfactant, Megafac F-176 (produced by Dainippon Ink & Chemicals, Inc.)
      W-2: fluorine/silicon-containing surfactant, Megafac R08 (produced by Dainippon Ink & Chemicals, Inc.)
      W-3: silicon-containing surfactant, Siloxane Polymer KP-341 (produced by Shin-Etsu Chemical Co., Ltd.) 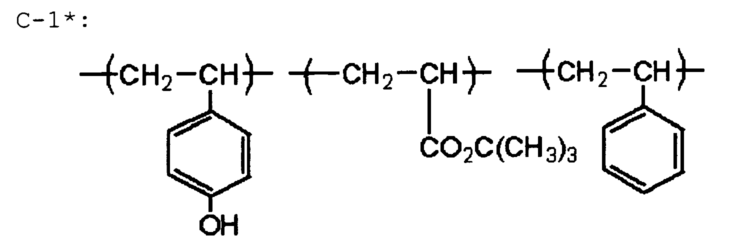 Molar compositional ratio: 65/20/15
         Weight average molecular weight: 12,500
         Dispersity: 1.88 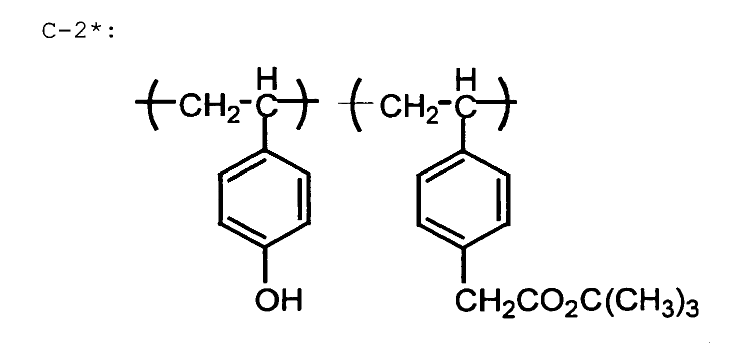 Molar compositional ratio: 75/25
         Weight average molecular weight: 13,500
         Dispersity: 1.78

It is seen from Table 2 that as regards the pattern formation by the irradiation with electron beams, the resist composition of the present invention exhibits high sensitivity and is excellent in terms of LWR and defocus latitude depended on line pitch, as compared with Comparative Examples.

### Example 8:

The preparation and coating of resist were performed in the same manner as in Example 1 to obtain a resist film, except that the amount of Resin (A-1) added was changed to 0.930 g and the amount of Sulfonic Acid Generator (B-2) added was changed to 0.030 g. The film thickness was 0.40 µm.

### Formation of Positive Pattern:

The resist film obtained was pattern-exposed using a KrF excimer laser stepper (FPA-3000EX-5, manufactured by Canon Inc., wavelength: 248 nm). The processing after the exposure was performed in the same manner as in Example 1. The evaluation of the pattern was performed as follows.

### Sensitivity:

The cross-sectional profile of the pattern obtained was observed using a scanning electron microscope (S-4300, manufactured by Hitachi, Ltd.). The minimum irradiation energy for resolving a 0.18-µm line (line:space = 1:1) was taken as the sensitivity.

### LWR (Line Width Roughness):

With respect to a resist pattern obtained in the same manner as above, the line width was observed by a scanning electron microscope (S-9220, manufactured by Hitachi, Ltd.) to inspect the line width fluctuation (LWR) in the line width of 130 nm. The line width was detected at a plurality of positions in the measuring monitor by using a length-measuring scanning electron microscope (SEM), and the amplitude dispersion (3σ) at the detection positions was used as an index for LWR.

### Defocus Latitude Depended on Line Pitch:

In a 0.18-µm line pattern at the irradiation dose giving the above-described sensitivity, the line width of a dense pattern (line:space = 1:1) and the line width of an isolated pattern were measured. The difference therebetween was taken as the defocus latitude depended on line pitch.

The evaluation results are shown in Table 3.

### Examples 9 to 14 and Comparative Examples 3 and 4:

The preparation and coating of a resist were performed thoroughly in the same manner as in Example 8 by using the compounds shown in Table 3, and the evaluation by KrF excimer laser exposure was performed.

The evaluation results are shown in Table 3.

**Table 3**

| | Resin | Acid Generator | Basic Compound (0.003 g) | Surfactant (0.001 g) | Sensitivity (mJ/cm²) | LWR (nm) | Defocus Latitude Depended on Line pitch (nm) |
|---|---|---|---|---|---|---|---|
| Example 8 | A-1 (0.93 g) | B-2 (0.03 g) | D-1 | W-1 | 12.1 | 7.2 | 11 |
| Example 9 | A-5 (0.35 g) | B-4 (0.03 g) | D-2 | W-1 | 12.3 | 8.2 | 12 |
| Example 10 | A-6 (0.35 g) | B-16 (0.03 g) | D-3 | W-2 | 11.9 | 8.3 | 11 |
| Example 11 | A-7 (0.25 g) | B-17 (0.03 g) | D-1 | W-2 | 15.2 | 7.7 | 12 |
| Example 12 | A-14 (0.35 g) | B-1 (0.03 g) | D-3 | W-1 | 14.2 | 8.6 | 10 |
| Example 13 | A-15 (0.35 g) | B-3 (0.03 g) | D-3 | W-1 | 11.6 | 7.9 | 10 |
| Example 14 | A-16 (0.35 g) | B-5 (0.03 g) | D-2 | W-1 | 12.9 | 6.8 | 11 |
| Comparative Example 3 | C-1* (0.93 g) | B-2 (0.03 g) | D-1 | W-1 | 20.1 | 11.1 | 23 |
| Comparative Example 4 | C-2* (0.93 g) | B-2 (0.03 g) | D-1 | W-1 | 23.2 | 14.3 | 27 |

It is seen from Table 3 that as regards the pattern formation by the KrF excimer laser exposure, the positive resist composition of the present invention exhibits high sensitivity and is excellent in terms of LWR and defocus latitude depended on line pitch, as compared with Comparative

### Examples.

### Examples 15 to 26 and Comparative Examples 5 and 6:

Using each resist composition shown in Table 4, a resist film was obtained in the same manner as in Example 1. However, the resist film thickness was changed to 0.13 µm. The resist film obtained was subjected to surface exposure using EUV light (wavelength: 13 nm, manufactured by Litho Tech Japan Co., Ltd.) by changing the exposure dose in steps of 0.5 mJ in the range from 0 to 5.0 mJ and then baked at 110°C for 90 seconds. Thereafter, the dissolution rate at each exposure dose was measured using an aqueous 2.38 mass% tetramethylammonium hydroxide (TMAH) solution to obtain a sensitivity curve. The exposure dose when the dissolution rate of the resist was saturated in this sensitivity curve was taken as the sensitivity and also, the dissolution contrast (γ value) was calculated from the gradient in the straight line part of the sensitivity curve. As the γ value is larger, the dissolution contrast is more excellent.

The results are shown in Table 4.

**Table 4**

| | Resin | Acid Generator | Basic Compound (0.003 g) | Surfactant (0.001 g) | Sensitivity (mJ/cm²) | γ value |
|---|---|---|---|---|---|---|
| Example 15 | A-1 (0.93 g) | B-2 (0.05 g) | D-1 | W-1 | 12.1 | 9.5 |
| Example 16 | A-8 (0.35 g) | B-4 (0.03 g) | D-2 | W-1 | 12.3 | 9.3 |
| Example 17 | A-9 (0.35 g) | B-16 (0.03 g) | D-3 | W-2 | 11.9 | 9.6 |
| Example 18 | A-17 (0.25 g) | B-17 (0.03 g) | D-1 | W-2 | 15.2 | 9.1 |
| Example 19 | A-18 (0.35 g) | B-1 (0.03 g) | D-3 | W-1 | 14.2 | 9.2 |
| Example 20 | A-19 (0.35 g) | B-3 (0.03 g) | D-3 | W-3 | 11.6 | 8.9 |
| Example 21 | A-20 (0.35 g) | B-5 (0.03 g) | D-2 | W-3 | 12.9 | 9.6 |
| Example 22 | A-21 (0.36 g) | B-2 (0.05 g) | D-1 | W-1 | 12.2 | 9.7 |
| Example 23 | A-22 (0.34 g) | B-4 (0.03 g) | D-2 | W-1 | 12.5 | 9.5 |
| Example 24 | A-23 (0.35 g) | B-16 (0.03 g) | D-3 | W-2 | 11.6 | 9.6 |
| Example 25 | A-24 (0.35 g) | B-17 (0.03 g) | D-1 | W-2 | 14.6 | 9.3 |
| Example 26 | A-25 (0.36 g) | B-1 (0.03 g) | D-3 | W-1 | 14.1 | 9.2 |
| Comparative Example 5 | C-1* (0.93 g) | B-2 (0.03 g) | D-1 | W-1 | 20.1 | 7.1 |
| Comparative Example 6 | C-2* (0.93 g) | B-2 (0.03 g) | D-1 | W-1 | 27.3 | 6.3 |

It is seen from Table 4 that in the characteristic evaluation by the irradiation with EUV light, the positive resist composition of the present invention is excellent by exhibiting high sensitivity and high contrast as compared with Comparative Examples.

According to the present invention, as regards the pattern formation by the irradiation of electron beam, KrF excimer laser light, EUV light or the like, a resist composition excellent in view of sensitivity, defocus latitude depended on line pitch, line width roughness and dissolution contrast, and a pattern forming method using the composition can be provided.

The entire disclosure of each and every foreign patent application from which the benefit of foreign priority has been claimed in the present application is incorporated herein by reference, as if fully set forth.

## Claims

1. A resist composition, comprising:
(A) a resin that contains a repeating unit represented by formula (I); and
(B) a compound capable of generating an acid upon irradiation with actinic rays or radiation: 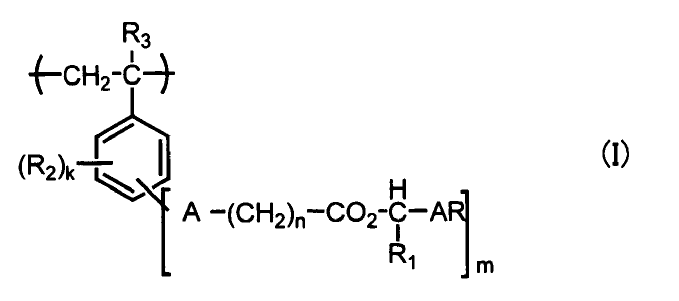 wherein AR represents a phenyl group or a naphthyl group;
R₁ represents an alkyl group, a cycloalkyl group or an aryl group;
AR and R₁ may combine with each other to form a ring;
R₂ represents, when a plurality of R₂s are present, each independently represents, a substituent;
R₁ and R₂ may combine with each other to form a ring;
R₃ represents a hydrogen atom, an alkyl group, a halogen atom, a cyano group or an alkyloxycarbonyl group;
A represents a single bond or a divalent linking group;
n represents an integer of 1 to 5;
m represents an integer of 1 to 3; and
k represents an integer of 0 to 3, provided that m and k satisfy m+k≤5.

2. The resist composition according to claim 1,
wherein the resin as the component (A) further contains a repeating unit represented by formula (A1): 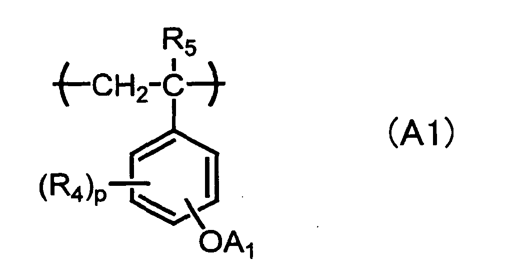 wherein A₁ represents a hydrogen atom or a group which leaves under an action of an acid;
R₄ represents, when a plurality of R₄s are present, each independently represents, a substituent;
R₅ represents a hydrogen atom, an alkyl group, a halogen atom, a cyano group or an alkyloxycarbonyl group; and
p represents an integer of 0 to 3.

3. The resist composition according to claim 1,
wherein the resin as the component (A) further contains a repeating unit represented by formula (A2): 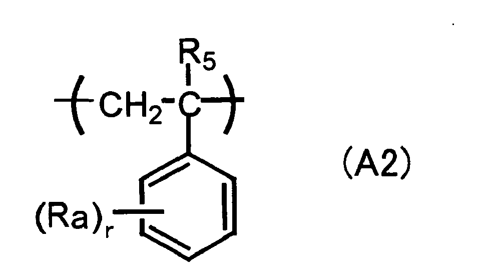 wherein Ra represents, when a plurality of Ra's are present, each independently represents, a substituent;
R₅ represents a hydrogen atom, an alkyl group, a halogen atom, a cyano group or an alkyloxycarbonyl group; and
r represents an integer of 0 to 5.

4. The resist composition according to claim 1,
wherein the resin as the component (A) further contains a repeating unit containing a (meth)acrylic acid derivative incapable of decomposing under an action of an acid.

5. The resist composition according to claim 1,
wherein a content of the repeating unit represented by formula (I) in the resin (A) is from 3 to 60 mol% based on all repeating units of the resin (A).

6. The resist composition according to claim 2,
wherein a content of the repeating unit represented by formula (A1) in the resin (A) is from 40 to 97 mol% based on all repeating units of the resin (A).

7. The resist composition according to claim 1,
wherein the resin (A) has a weight average molecular weight (Mw) of from 1,000 to 50,000.

8. A pattern forming method, comprising:
forming a resist film from the resist composition according to claim 1; and
exposing and developing the resist film.
